# EUROPEAN PATENT APPLICATION

(11) **EP 4 489 543 A2**
(43) Date of publication of application: **08.01.2025**
(21) Application number: 24179083.1
(22) Date of filing: 30.05.2024
(51) Int. Cl.: H10B 12/00

(54) **SEMICONDUCTOR DEVICE**

(30) Priority: 04.07.2023 KR 20230086196
(71) Applicant: Samsung Electronics Co., Ltd., Suwon-si, Gyeonggi-do 16677 (KR)
(72) Inventor: LEE, Kiseok, 16677 Suwon-si (KR); KIM, Bongsoo, 16677 Suwon-si (KR); KIM, Yongkwan, 16677 Suwon-si (KR); KIM, Jongmin, 16677 Suwon-si (KR); PARK, Taejin, 16677 Suwon-si (KR); YOON, Chansic, 16677 Suwon-si (KR); HAN, Jinwoo, 16677 Suwon-si (KR)
(74) Representative: Marks & Clerk LLP

(57) **Abstract**

A semiconductor device includes an active array in which a plurality of active patterns are arranged on a substrate; a gate structure extending in a first direction and crossing central portions of the active patterns; a bit line structure contacting first portions of the active patterns adjacent to a first sidewall of the gate structure and extending in a second direction; and a capacitor electrically connected to a second portion of each of the active patterns adjacent to a second sidewall of the gate structure. In a plan view, an upper end portion of each of the active patterns and a lower end portion of each of the active patterns are arranged to be spaced apart in a third direction oblique with respect to the first direction. The active patterns arranged side by side in the second direction form an active column.

## Description

### BACKGROUND

A DRAM device includes one transistor and one capacitor in one memory cell. In general, two memory cells can be formed within one isolated active pattern in the DRAM device. To achieve a highly integrated DRAM device, active patterns and transistors and capacitors on the active patterns are appropriately arranged.

### SUMMARY

This disclosure provides a semiconductor device having a high degree of integration. Various examples relate to DRAM devices.

In a general aspect, a semiconductor device includes: an active array in which a plurality of active patterns are arranged on a substrate; a gate structure extending in a first direction parallel to an upper surface of the substrate and crossing central portions of the active patterns; a bit line structure contacting first portions of the active patterns adjacent to a first sidewall of the gate structure, and extends in a second direction parallel to the upper surface of the substrate and perpendicular to the first direction; and a capacitor electrically connected to a second portion of each of the active patterns adjacent to a second sidewall of the gate structure. In a plan view, an upper end portion of each of the active patterns and a lower end portion of each of the active patterns are arranged to be spaced apart in a third direction oblique with respect to the first direction. The active patterns arranged side by side in the second direction form an active column.

In another general aspect, a semiconductor device includes: an active array in which a plurality of active patterns are arranged on a substrate;a gate structure extending in a first direction parallel to an upper surface of the substrate and crossing central portions of the active patterns, and wherein each of the active patterns are divided into a first portion and a second portion by the gate structure; a bit line structure contacting the first portions of the active patterns, and extending in a second direction parallel to the upper surface of the substrate and perpendicular to the first direction, and the bit line structure including a bit line pattern having a conductive material and a first insulation pattern stacked; and capacitors electrically connected to second portions of the active patterns, respectively. In a plan view, an upper end portion of each of the active patterns and a lower end portion of each of the active patterns are arranged to be spaced apart in a third direction oblique with respect to the first direction. An upper surface of the first portion of each of the active patterns is lower than an upper surface of the second portion of the active pattern.

In another general aspect, a semiconductor device includes: an active array in which a plurality of active patterns are arranged on a substrate;a gate structure extending in a first direction parallel to an upper surface of the substrate and crossing central portions of the active patterns, and wherein each of the active patterns are divided into a first portion and a second portion by the gate structure; a bit line structure contacting the first portions of the active patterns, and extending in a second direction parallel to the upper surface of the substrate and perpendicular to the first direction, and the bit line structure including a bit line pattern having a conductive material and a first insulation pattern stacked; and an insulation spacer disposed between a sidewall of a second portion of the active pattern and a sidewall of the bit line structure, and extending in the second direction; first contact plugs contacting upper surfaces of second portions of the active patterns, respectively, and each of the first contact plugs having an isolated shape; a second insulation pattern between the first contact plugs in a second direction; and a capacitor electrically connected to each of the first contact plugs.

In some implementations, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.

In some implementations, the third direction corresponds to a direction along which each of the active patterns extends.

In some implementations, in a plan view, the active patterns that are arranged side by side in the first direction define an active row. At least a portion of the active patterns included in an even-numbered active row can be disposed between adjacent active patterns include in an odd-numbered active row.

In some implementations, the gate structure is in a first recess on the active patterns.

In some implementations, an upper surface of the first portion of the active pattern is lower than an upper surface of the second portion of the active pattern.

In some implementations, an insulation spacer extends in the second direction and is defined (e.g. extends) between a sidewall of the second portion of the active pattern and a sidewall of the bit line structure.

In some implementations, the bit line structure includes a bit line pattern including a conductive material and a first insulation pattern.

In some implementations, the semiconductor device includes a metal silicide pattern between the bit line pattern and an upper surface of the first portion of the active pattern.

In some implementations, the semiconductor device a first contact plug having an isolated shape and contacting an upper surface of the second portion of each of the active patterns; and a second contact structure contacting at least a portion of the upper surface of the first contact plug. The capacitor can contact the second contact structure.

In some implementations, second contact structures are arranged in a honeycomb structure disposed at each vertex of connected hexagons and a center of each of the hexagons.

In some implementations, an uppermost surface of the first contact plug is lower than an uppermost surface of the bit line structure.

In some implementations, the semiconductor device includes a second insulation pattern between the first contact plugs in the second direction. The first contact plug and the second insulation pattern can be aligned with the second direction.

In some implementations, the semiconductor device includes: a contact plug contacting an upper surface of the second portion of the active pattern, and an upper portion of the contact plug including a recessed portion; a landing pad pattern contacting at least a portion of the upper surface of the contact plug; and a third insulation pattern filling an opening between landing pad patterns and contacting the recessed portion.

In some implementations, landing pad patterns are arranged in a honeycomb structure disposed at each vertex of connected hexagons and a center of each of the hexagons.

In some implementations, an uppermost surface of the contact plug is higher than an uppermost surface of the bit line structure.

In some implementations, the semiconductor device includes a first contact plug having an isolated shape and contacting an upper surface of the second portion of each of the active patterns. The capacitor can contact at least a portion of the upper surface of the first contact plug.

In some implementations, the capacitor includes a lower electrode, a dielectric layer, and an upper electrode. Lower electrodes can be arranged in a honeycomb structure disposed at each vertex of connected hexagons and a center of each of the hexagons.

In some implementations, the active patterns that are arranged side by side in the second direction define an active column, and the active patterns that are arranged side by side in the first direction define an active row. First portions of the active patterns included in the active column can be arranged in the second direction, and central portions of active patterns included in the active row can be arranged in the first direction.

In some implementations, in a plan view, active columns are repeatedly arranged in the first direction.

In some implementations, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.

In some implementations, the semiconductor device includes a metal silicide pattern between the bit line pattern and an upper surface of the first portion of the active pattern.

In some implementations, a first contact plug having an isolated shape and contacting an upper surface of the second portion of each of the active patterns; and a second contact structure contacting at least a portion of the upper surface of the first contact plug. The capacitor can contact the second contact structure.

In some implementations, in a plan view, an upper end portion of each of the active patterns and a lower end portion of each of the active patterns are arranged to be spaced apart in a third direction oblique with respect to the first direction. The active patterns that are arranged side by side in the second direction define an active column, and active columns are repeatedly arranged in the first direction.

In some implementations, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.

In some implementations, the semiconductor device includes a second contact structure between the first contact plug and the capacitor. The second contact structure can contact at least a portion of an upper surface of the first contact plug.

In various examples, processes of forming the active patterns of the semiconductor device are described. Additionally, one gate structure and one capacitor may be disposed in each of the active patterns, and accordingly, one memory cell may be formed in each of the active patterns. The semiconductor device may be highly integrated, and elements included in the semiconductor device may be easily formed.

At least some of the above and other features of the invention are set out in the claims.

### BRIEF DESCRIPTION OF THE DRAWINGS

FIG. 1 is a plan view schematically illustrating an example semiconductor device.
FIGS. 2 to 4 are a plan view and cross-sectional views illustrating an example semiconductor device.
FIGS. 5A to 5H are plan views illustrating example active patterns included in the semiconductor devices.
FIGS. 6 to 43 are plan views and cross-sectional views illustrating examples of methods of manufacturing an example of a semiconductor device.
FIGS. 44A and 44B are cross-sectional views for illustrating example semiconductor devices.
FIG. 45 is cross-sectional views for illustrating an example method of manufacturing a semiconductor device.
FIG. 46 is cross-sectional views for illustrating an example method of manufacturing a semiconductor device.
FIG. 47 is a plan view illustrating an example semiconductor device.
FIGS. 48A and 48B are cross-sectional views illustrating example semiconductor devices.
FIGS. 49A, 49B, FIGS. 50A, and 50B are cross-sectional views for illustrating an example method of manufacturing a semiconductor device.
FIGS. 51, 52, and 53 are a plan view and cross-sectional views for illustrating example semiconductor devices.
FIGS. 54 and 55 are cross-sectional views for illustrating example semiconductor devices.

### DETAILED DESCRIPTION

In the detailed description below, two directions parallel to an upper surface of a substrate and perpendicular to each other are defined as first and second directions, respectively. A direction parallel to the upper surface of the substrate and obliquely extending with respect to the first direction is defined as a third direction. It will be understood that directions discussed herein are example directions expressed relative to a given device. These example directions do not imply any particular orientation of such a device.

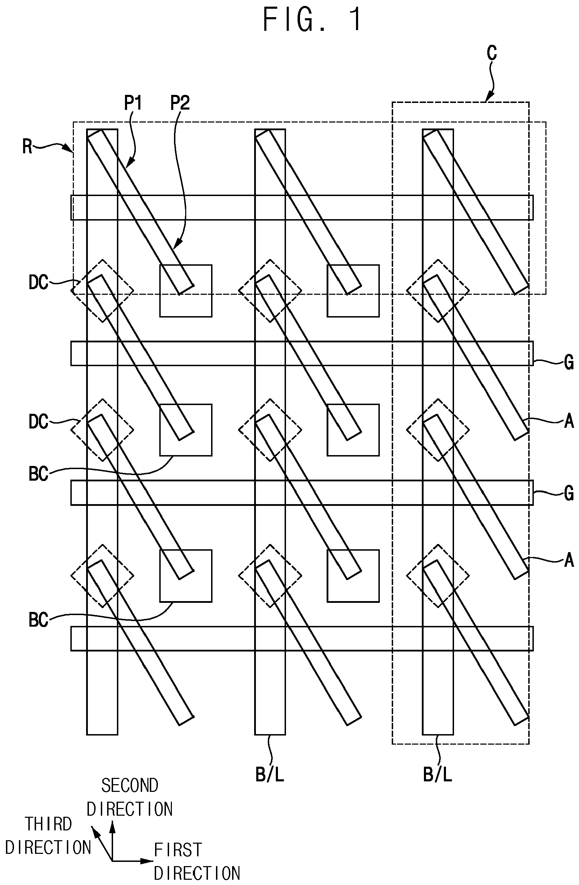

FIG. 1 is a plan view schematically illustrating an example of a semiconductor device.

In the following examples of semiconductor devices, one memory cell may be disposed within one isolated active pattern on a substrate. For example, one transistor and one capacitor may be formed on the one isolated active pattern.

Referring to FIG. 1, the active patterns A are repeatedly arranged in each of the first and second directions. The active patterns A arranged in each of the first and second direction form an active array.

An upper end portion of the active pattern A and a lower end portion of the active pattern A may be spaced apart from in the third direction. When the upper end portion of the active pattern A and the lower end portion of the active pattern A are directly connected to each other, it may have a line shape extending in the third direction. In some implementations, the third direction corresponds to a longitudinal direction (e.g., an extension direction) of the active pattern A, that is a direction in which the active pattern extends.

The active patterns A arranged side by side in the first direction may form an active row R. The active patterns A arranged side by side in the second direction may form an active column C. At least a portion of the active patterns A included in an even-numbered active row R may be positioned between adjacent active patterns A included in an odd-numbered active row R.

Identical active columns C may be repeatedly arranged in the first direction. In some implementations, adjacent active columns C may be disposed symmetrically with respect to a straight line extending in the second direction. The active patterns A included in the active column C may be arranged in the second direction.

In some implementations, preliminary mask patterns may be formed on the substrate, and then the preliminary mask patterns may be separated by performing an etching process to form mask patterns. Additionally, the substrate may be etched using the mask patterns as an etch mask to form the active patterns A.

The active patterns A may have various arrangements based on arrangements of the mask patterns. The arrangement of the active patterns A will be described in detail later.

In the plan view of FIG. 1, e.g., along a direction perpendicular to both the first and second directions, one gate structure G extending in the first direction may be disposed on the one active pattern A. The gate structure G crosses a central portion of the active patterns A included in the active row R. The one active pattern A may be divided into a first portion P1 and a second portion P2 by the gate structure G. Hereinafter, in the one active pattern A, a portion positioned above based on the gate structure G is referred to as the first portion P1, and a portion positioned below based on the gate structure G is referred to as the second portion P2. Here "above" and "below" are expressed in the plan review with respect to the directions thereof.

A bit line structure B/L may extend in the second direction while being electrically connected to the first portion P1 of the active patterns A included in the active column C. For example, an additional contact plug may not be disposed between the bit line structure B/L and the first portion P1 of the active pattern A. The bit line structure B/L may directly contact the first portion P1 of the active pattern A. A contact region between the bit line structure B/L and the active pattern A may be indicated as DC.

A capacitor may be electrically connected to the second portion P2 of the active pattern A. For example, at least one of a contact plug BC and a landing pad pattern may be formed between the second portion P2 of the active pattern A and the capacitor. Accordingly, the capacitor may be electrically connected to the second portion P2 of the active pattern A through at least one of the contact plug BC and the landing pad pattern.

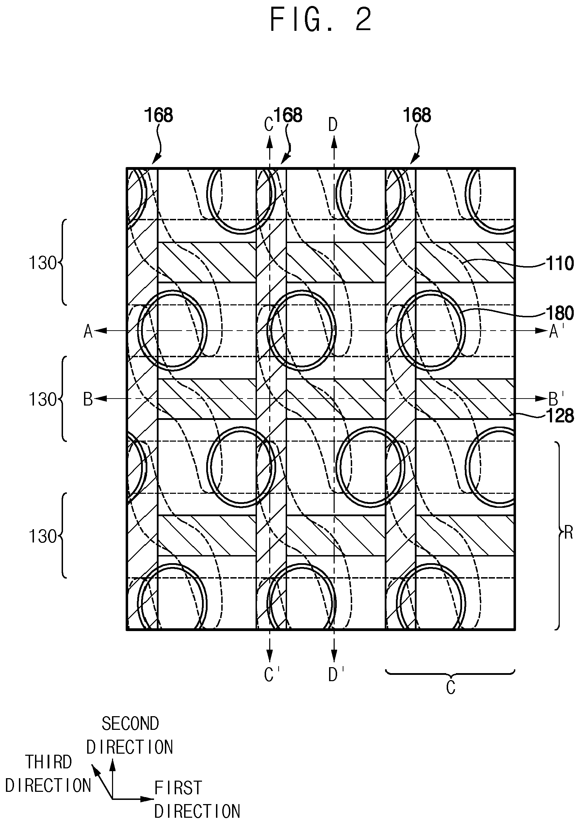

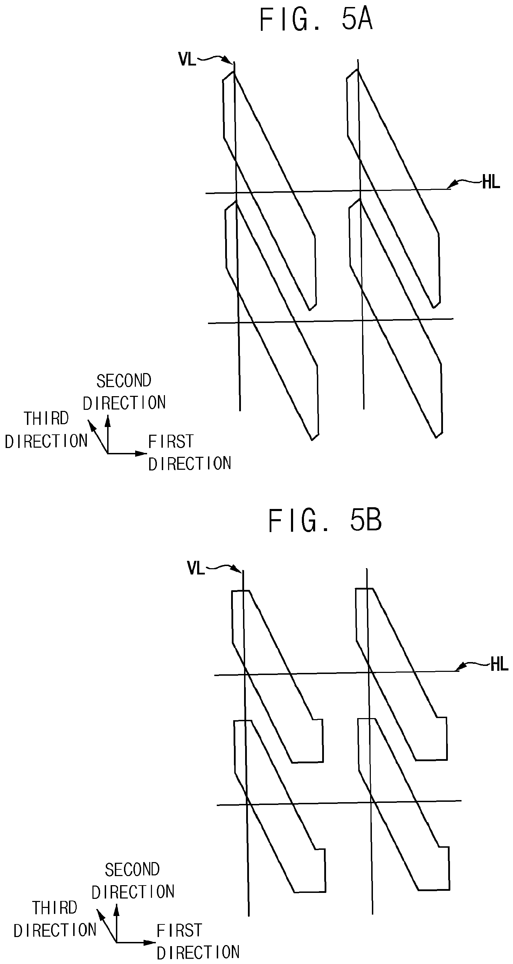

FIGS. 2 to 4 are plan and cross-sectional views illustrating examples of a semiconductor device. FIGS. 5A to 5H are plan views illustrating examples of active patterns included in the semiconductor devices.

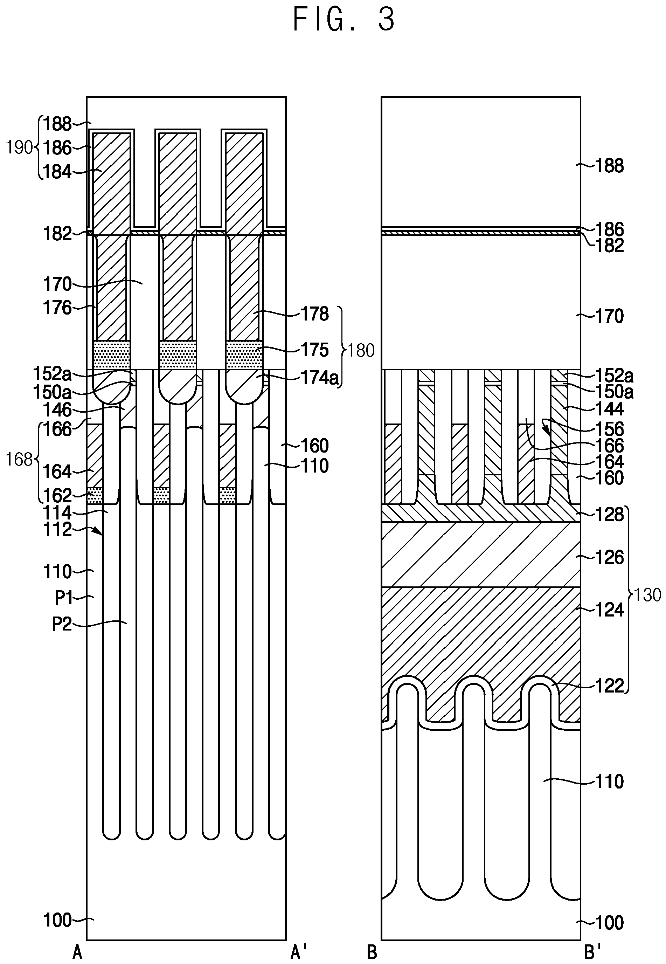

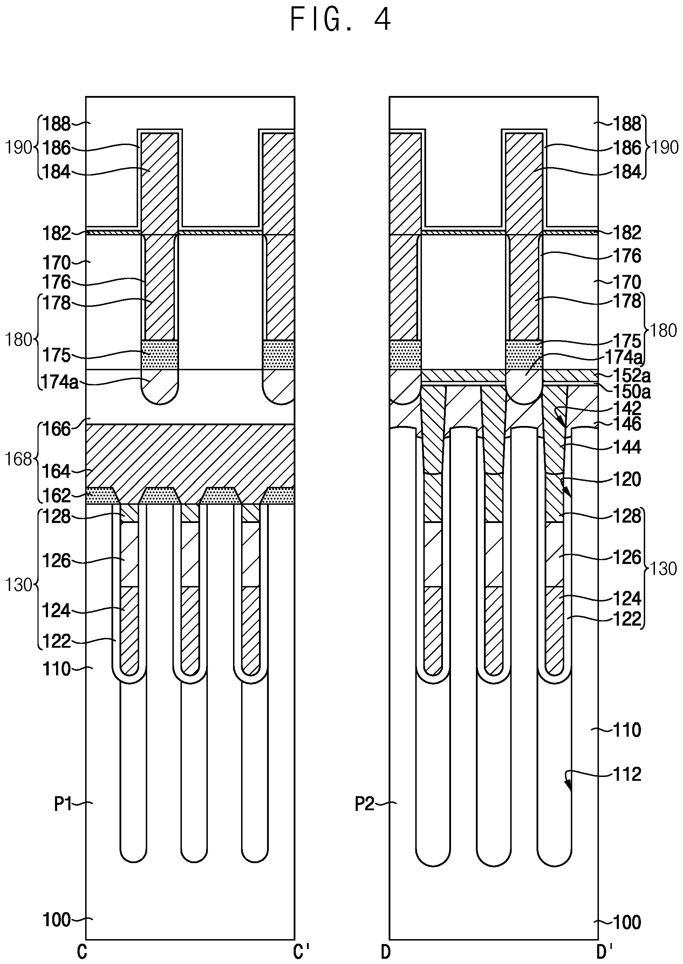

FIG. 2 illustrates only some components of the semiconductor device. FIG. 3 includes cross-sectional views taken along lines A-A' and B-B' of FIG. 2. FIG. 4 includes cross-sectional views taken along lines C-C' and D-D' of FIG. 2.

Referring to FIGS. 2 to 4, a device isolation trench 112 and active patterns 110 are on the substrate 100. A device isolation pattern 114 may be formed in the device isolation trench 112.

The substrate 100 may include a semiconductor material such as silicon, germanium, silicon-germanium, etc., or a group III-V compound such as GaP, GaAs, GaSb, etc. In some implementations, the substrate 100 may be a Silicon on Insulator (SOI) substrate or a Germanium on Insulator (GOI) substrate.

A protruding portion of the substrate 100 between the device isolation trenches 112 may be defined as the active pattern 110, and the active pattern 110 may include a material that is the same material as the substrate 100. The device isolation pattern 114 may include an insulation material, e.g., silicon oxide.

In the plan view, upper and lower end portions of the active pattern 110 may be spaced apart from each other in the third direction. For example, the active pattern 110 may have an isolated shape extending in the third direction. In the example of FIGS. 2 to 4, the active pattern 110 does not contact other active patterns, extending in the third direction. In the plan view, a sidewall of the active pattern 110 may have a straight shape, a curved shape, or a wavy shape. In some implementations, an acute angle between the first direction and the third direction may be in range of about 30 degrees to about 75 degrees.

The active patterns 110 may be aligned in the first direction to form the active row R. The active patterns 110 may be aligned in the second direction to form the active column C. The active row R and the active column C may form an active array.

Identical active columns C may be repeatedly arranged in the first direction. In some implementations, adjacent active columns C may be disposed symmetrically with respect to a straight line extending in the second direction. The active patterns 110 included in the active column C may be arranged in in the second direction.

At least a portion of the active patterns 110 included in the even-numbered active row R may be positioned between adjacent active patterns 110 included in the odd-numbered active row R.

In the plan view, the lower end portions of the active patterns 110 included in the even-numbered active row R may be adjacent to the upper end portions of the active patterns 110 included in the odd-numbered active row R in the first direction. The lower end portion of the active pattern 110 included in the even-numbered active row R and the upper end portion of the active pattern 110 included in the odd-numbered active row R may be alternately disposed in the first direction. The upper end portions and the lower end portions of active patterns 110 disposed in different adjacent active rows R may be aligned in the first direction.

Additionally, the upper end portions of the active patterns 110 included in the same active column C may be aligned in the second direction. The lower end portions of the active patterns 110 included in the same active column C may be aligned in the second direction. In each of the active rows R, the central portion of the active pattern 110 may be aligned in the first direction.

The active patterns 110 included in the active array may be designed with various shapes to have an arrangement as described above.

In FIGS. 5A to 5H, horizontal lines HL indicate a position for forming the gate structures, and vertical lines VL indicate a position for forming bit line structures. Hereinafter, an upper end portion, a lower end portion, an upper portion, and a lower portion of the active pattern may be positions of the active pattern in the plan view. In FIGS. 5A to 5H, the upper portion of the active pattern refers to a portion above the horizontal line HL, and the lower portion of the active pattern refers to a portion under the horizontal line HL. In FIGS. 5A to 5H, the upper end portion of the active pattern refers to an uppermost portion in the second direction, and the lower end portion refers to an lowermost portion in the second direction.

In some implementations, as shown in FIG. 5A, both sidewalls of the active pattern 110 are straight and extend in the third direction. The upper and lower end portions of the active pattern 110 are straight and extend in the second direction. An angle between the third direction (e.g., a direction of in which the extent of the active pattern 110 is greatest) and the first direction may be in a range of about 50 degrees to about 75 degrees.

In some implementations, as shown in FIG. 5B, both sidewalls of the active pattern 110 are straight and extend in the third direction. The lower portion of the active pattern 110 includes a bent portion bent in the first direction. Additionally, the upper and lower end portions of the active pattern 110 are straight and extend in the second direction.

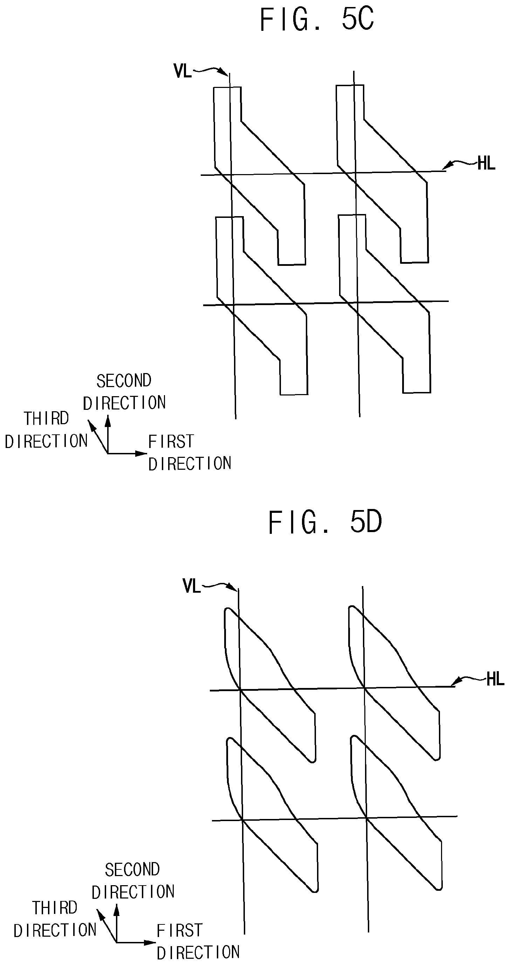

In some implementations, as shown in FIG. 5C, both sidewalls of the active pattern 110 are straight and extend in the third direction. The lower and upper portions of the active pattern 110 may include bent portions bent in the second direction. Additionally, the upper and lower portions of the active pattern 110 may extend in the second direction.

In some implementations, as shown in FIG. 5D, both sidewalls of the active pattern 110 are curved and extend in the third direction. The upper and lower end portions of the active pattern 110 may extend in the second direction. A length in the second direction of the upper end portion of the active pattern 110 may be greater than a length in the second direction of the lower portion of the active pattern 110. An upper sidewall of the active pattern 110 may protrude from a lower sidewall of the active pattern 110.

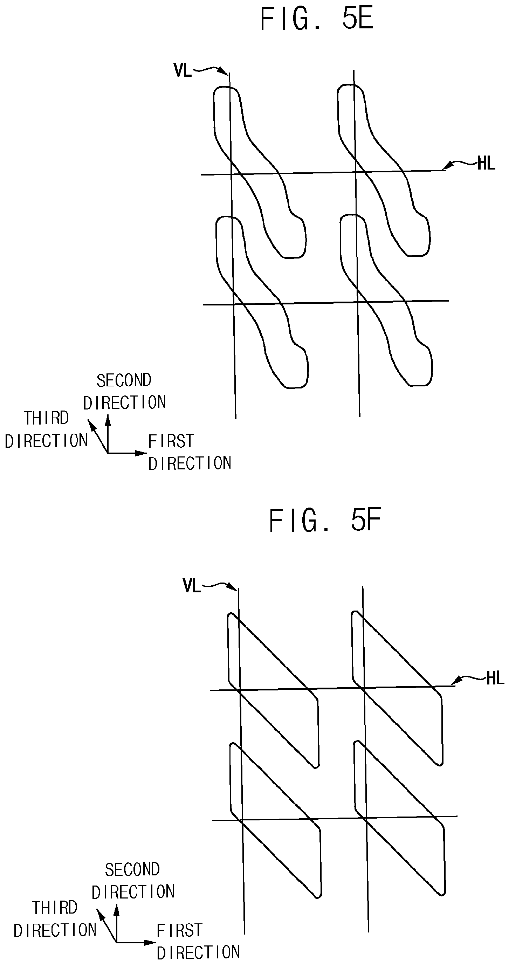

In some implementations, as shown in FIG. 5E, both sidewalls of the active pattern 110 are curved and extend in the third direction. The lower portion of the active pattern 110 may include a first bent portion bent in the first direction. The upper portion of the active pattern 110 may include a second bent portion bent in the second direction. The upper end portion of the active pattern 110 may extend in the first direction, and a lower end portion of the active pattern 110 may extend in the second direction.

In some implementations, as shown in FIG. 5F, both sidewalls of the active pattern 110 are straight and extend in the third direction. The upper end portion and the lower end portion of the active pattern 110 may extend in the second direction. An angle between e.g., an extending direction of the active pattern 110 and the first direction may be in a range of about 30 degrees to about 50 degrees.

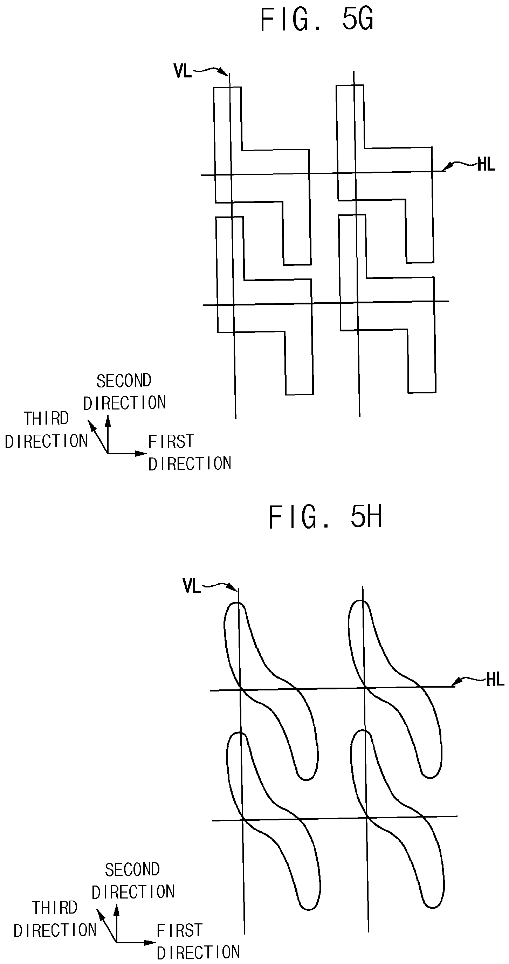

In some implementations, as shown in FIG. 5G, the active pattern 110 may include a third portion (e.g., an upper portion) and a fifth portion (e.g., a lower portion) extending in the second direction, and a fourth portion (e.g., a middle portion) between the third and fifth portions and extending in the first direction. Each of the third portion, the fourth portion and the fifth portion of the active pattern 110 may have a straight line shape. In each of the active patterns, the upper end portion of the active pattern may be spaced apart from a lower end portion of the active pattern in the third direction.

In some implementations, as shown in FIG. 5H, both sidewalls of the active pattern 110 are curved and extend in the third direction. The upper portion of the active pattern 110 may include a first bent portion bent in the second direction, and the lower portion of the active pattern 110 may include a second bent portion bent in the second direction.

Hereinafter, the semiconductor device formed on the active pattern 110 shown in FIG. 5H may be described. However, the semiconductor device may be formed on the active pattern 110 having various shapes as shown in FIGS. 5A to 5G.

Again, referring to FIGS. 2 to 4, a first recess 120 extending in the first direction may be disposed on the active pattern 110 and the device isolation pattern 114, and a gate structure 130 may be in the first recess 120. That is, the gate structure 130 may extend through portions of the active pattern 110 and the device isolation pattern. The gate structure 130 may serve as a word line.

One gate structure 130 may be disposed on one active pattern 110. Each of gate structures 130 may extend in the first direction while crossing a plurality of active patterns 110 included in the same active row R.

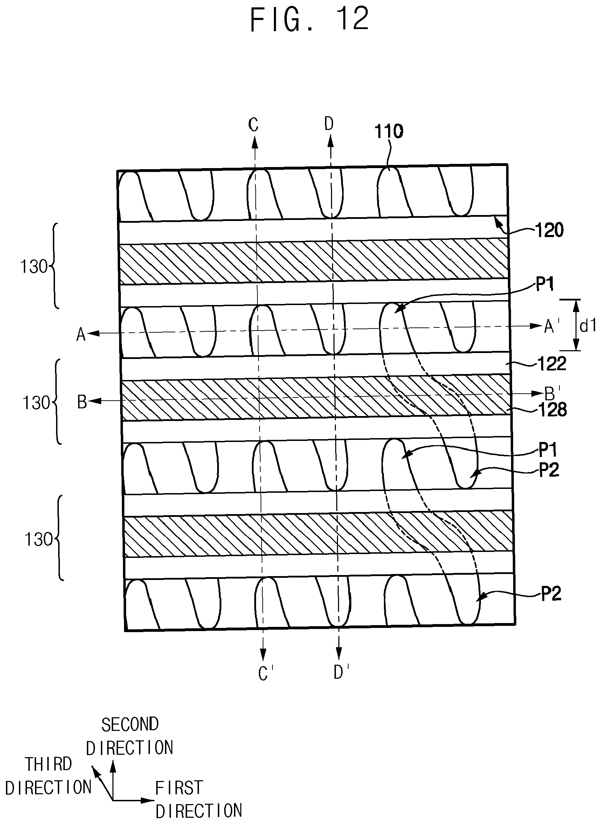

In some implementations, the gate structure 130 may cross central portions in the third direction of the active patterns 110. In a plan view, the active pattern 110 may be divided into the first and second portions (P1 and P2, referred to as FIG. 12) by the gate structure 130. In the plan view, in the active pattern 110, the first portion P1 may be above the gate structure 130, and the second portion P may be below the gate structure 130. In the active pattern 110, the first portion P1 may be a portion adjacent to the first sidewall of the first recess 120, and the second portion P2 may be a portion adjacent to the second sidewall of the first recess 120.

Although not shown, first and second impurity regions may be formed in the first portion P1 and the second portion P2 of the active pattern 110, respectively. Accordingly, the gate structure 130 and the first and second impurity regions may serve as a cell transistor. For example, the first and second impurity regions may be doped with n-type impurities.

In some implementations, the gate structures 130 may be regularly arranged to be spaced apart from each other. Distances between the gate structures 130 in the second direction may be substantially equal to each other.

In some implementations, the gate structure 130 may include a gate insulation pattern 122, a first gate pattern 124, a second gate pattern 126, and a gate mask 128. The gate insulation pattern 122 may include an oxide such as silicon oxide. The first gate pattern 124 may include a metal, and the second gate pattern 126 may include polysilicon. The metal included in the first gate pattern 124 may include tungsten. The gate mask 128 may include nitride, such as silicon nitride.

In some implementations, the gate insulation pattern 122 may be on an upper surface and sidewalls of the active pattern 110 exposed by a lower portion of the first recess 120. Therefore, the gate structure 130 may serve as a gate of a fin field effect transistor.

Edges of different active patterns 110 may be exposed on a region between neighboring two gate structures 130. In the region between neighboring two gate structures 130, the first portion P1 and the second portion P2 of the active patterns 110 may be repeatedly and alternately arranged in the first direction.

A height (e.g., vertical level) of an upper surface of the first portion P1 of the active pattern 110 may be lower than a height of an upper surface of the second portion P2 of other active pattern 110 adjacent to the first portion of the active pattern 110 in the first direction.

First contact plugs 146 having an isolated shape, e.g., first contact plugs 146 do not contact other first contact plugs, may contact upper surfaces of the second portions P2 of the active patterns 110, respectively. A first insulation pattern 144 may be disposed between the first contact plugs 146 in the second direction. The first contact plugs 146 and first insulation patterns 144 may be arranged to be aligned in the second direction. The first insulation patterns 144 may contact an upper surface of the gate mask 129 of the gate structure 130.

In some implementations, the first contact plug 146 may include polysilicon doped with impurities. In some implementations, the first insulation pattern 144 may include silicon nitride.

The first contact plug 146 and the first insulation pattern 144 may be alternately and repeatedly arranged in the second direction. A structure in which the first contact plugs 146 and the first insulation patterns 144 are alternately arranged may have a line shape extending in the second direction and may be referred to as a first line structure. Each of both sidewalls of the first line structure may have a straight line shape.

A first buffer layer pattern 150a and a second buffer layer pattern 152a may be on an upper surface of the first line structure. In some implementations, the first buffer layer pattern 150a may include silicon oxide, and the second buffer layer pattern 152a may include silicon nitride.

A second opening 156 extending in the second direction may be disposed between the first line structures. The first portion P1 of the active pattern 110, the device isolation pattern 114, and the gate mask 128 of the gate structure 130 may be exposed by a bottom of the second opening 156. The first portion P1 of the active pattern 110 and the gate mask 128 of the gate structure 130 may be alternately and repeatedly arranged on the bottom of the second opening 156 in the second direction. The gate mask 128 exposed by the bottom of the second opening 156 may have a partially etched shape, and thus an upper surface of the gate mask 128 exposed by the bottom of the second opening 156 may be relatively lower than an upper surface of the gate mask 128 adjacent to the bottom of the second opening 156.

An insulation spacer 160 may be on a sidewall of the second opening 156. The insulation spacer 160 may cover the active pattern 110, the first contact plug 146, the first insulation pattern 144, the first and second buffer layer patterns 150a and 152a, and the gate mask 128 exposed by the sidewall of the second opening 156. The first portion P1 of the active pattern 110 may be exposed by the bottom of the second opening 156 between the insulation spacers 160.

In some implementations, the insulation spacer 160 may include silicon oxide.

A bit line structure 168 may be formed in the second opening 156 between the insulation spacers 160. The bit line structure 168 may extend in the second direction, and may directly contact the upper surface of the first portion P1 of the active pattern 110. Accordingly, the insulation spacer 160 may be between the bit line structure 168 and the second portion P2 of the active pattern 110. The insulation spacer 160 may extend in the second direction.

In some implementations, the bit line structure 168 may include a first metal silicide pattern 162, a bit line pattern 164, and a second insulation pattern 166.

The first metal silicide pattern 162 may include metal silicide, such as cobalt silicide, nickel silicide, or titanium silicide. For example, the bit line pattern 164 may include a metal such as tungsten, niobium, copper, aluminum, etc. The second insulation pattern 166 may include silicon nitride.

In some implementations, the first metal silicide pattern 162 may be disposed only on the first portion P1 of the active pattern 110 exposed by the second opening 156. Accordingly, the first metal silicide patterns 162 may be arranged to be spaced apart from each other in the second direction. In this case, the bit line structure 168 may include the first metal silicide pattern 162, the bit line pattern 164, and second insulation pattern 166 stacked on the first portion P1 of the active pattern 110 in the second opening 156. The bit line structure 168 may include the bit line pattern 164 and the second insulation pattern 166 stacked on the gate mask 128.

In some implementations, the first metal silicide pattern 162 may be formed on an entire bottom of the second opening 156. That is, the first metal silicide pattern 162 may be disposed on the first portion P1 of the active pattern 110 and the upper surface of the gate mask 128 exposed by the second opening 156. Accordingly, the first metal silicide pattern 162 may extend in the second direction. The bit line structure 168 may include the first metal silicide pattern 162, the bit line pattern 164 and the second insulation pattern 166 stacked on the first portion P1 of the active pattern 110 and the gate mask 128 exposed by the second opening 156.

In some implementations, uppermost surfaces of the bit line structure 168, the insulation spacer 160, and the second buffer layer pattern 152a may be coplanar with each other and may be substantially flat.

In some implementations, a bottom surface of the bit line structure 168 may be lower than an uppermost surface of the second portion P2 of the active pattern 110. In a cross-sectional view, the sidewall of the bit line structure 168 may face at least a portion of the sidewall of the second portion P2 of the active pattern 110.

In some implementations, an uppermost surface of the first contact plug 146 may be lower than the uppermost surface of the bit line structure 168.

A first mold layer 170 may cover upper surfaces of the bit line structure 168, the insulation spacer 160, the second buffer layer pattern 152a, and the second insulation pattern 166. The first mold layer 170 may include an insulation material having an etch selectivity with respect to silicon oxide. The first mold layer 170 may include silicon nitride, SiOCN, or SiOC.

A second contact structure 180 may pass through the first mold layer 170 and may contact the first contact plug 146. The second contact structure 180 may contact a portion of the first contact plug 146. The second contact structure 180 and the first contact plug 146 may be electrically connected to the second portion P2 of the active pattern.

The central portion of the second contact structure 180 may be offset relative to the central portion of the first contact plug 146 in a vertical direction, e.g., a direction perpendicular to both the first and second directions.

In some implementations, the second contact structure 180 may contact the first contact plug 146 and the insulation spacer 160 and second insulation pattern 166 adjacent to the first contact plug 146. A bottom surface of the second contact structure 180 may be lower than the uppermost surface of the first contact plug 146.

In some implementations, an uppermost surface of the second contact structure 180 may be higher than the uppermost surface of the bit line structure 168.

In some implementations, the second contact structure 180 may include a second silicon pattern 174a doped with impurities, a second metal silicide pattern 175, and a second contact plug 178.

The second metal silicide pattern 175 may include metal silicide, such as cobalt silicide, nickel silicide, or titanium silicide. For example, the second contact plug 178 may include a metal such as tungsten, niobium, copper, or aluminum.

In some implementations, an inner spacer 176 may surround a sidewall of the second contact plug 178. The inner spacer 176 may include an insulation material. The inner spacer 176 may include silicon nitride.

In some implementations, a plurality of second contact plugs 178 may be arranged in a honeycomb structure disposed at each vertex of connected hexagons and a central portion of each of the hexagons.

An etch stop layer 182 may be on the second contact plugs 178 and the first mold layer 170. The etch stop layer 182 may include silicon nitride.

A capacitor 190 may pass through the etch stop layer 182 and may be on the second contact plug 178. The capacitor 190 may include a lower electrode 184, a dielectric layer 186, and an upper electrode 188. The lower electrode 184 may pass through the etch stop layer 182 and may contact the second contact plug 178. Accordingly, the lower electrode 184 of the capacitor 190 may be electrically connected to the second portion P2 of the active pattern 110 via the second contact structure 180 and the first contact plug 146.

A plurality of lower electrodes 184 may be arranged in the honeycomb structure. In some implementations, the lower electrode 184 may have a pillar shape or a cylinder shape.

One gate structure 130 and one capacitor 190 may be disposed on one active pattern 110. One memory cell may be disposed on the one active pattern 110. The gate structure 130 may extend in the first direction to cross the central portion in the third direction of the active pattern 110. The bit line structure 168 may extend in the second direction, and directly contact the first portion P1 of the active pattern 110.

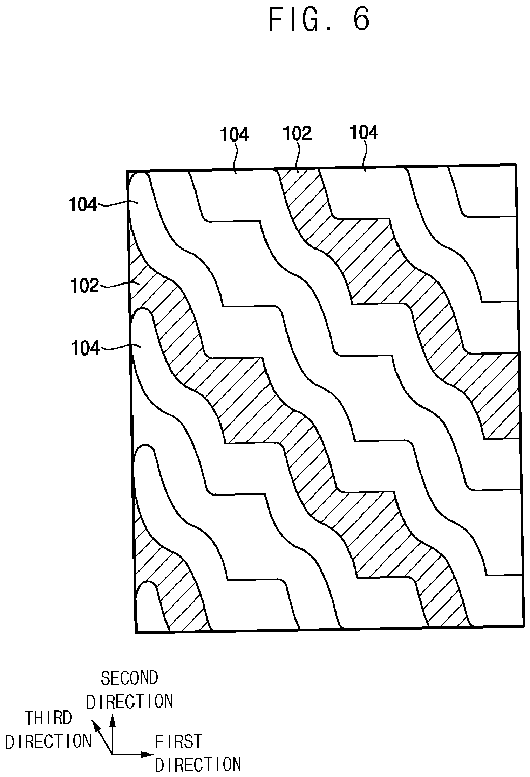

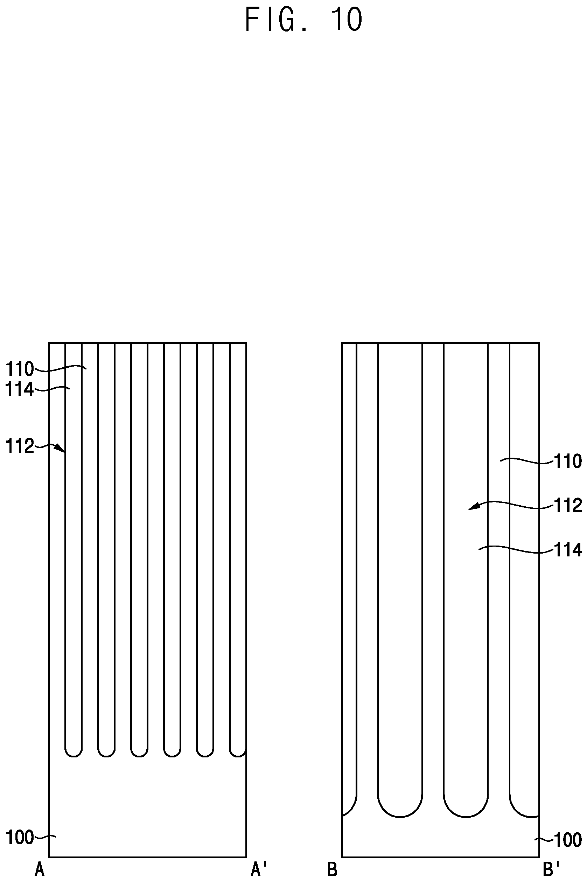

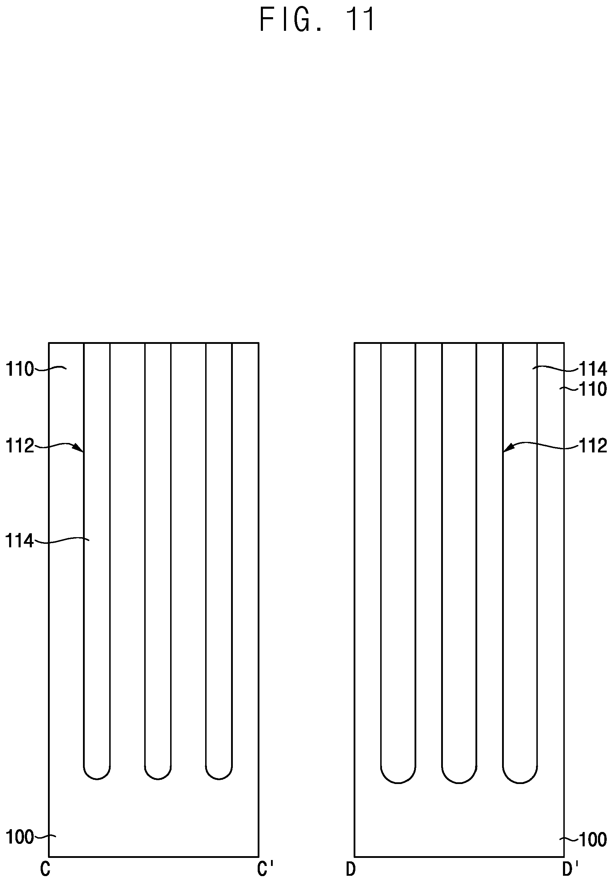

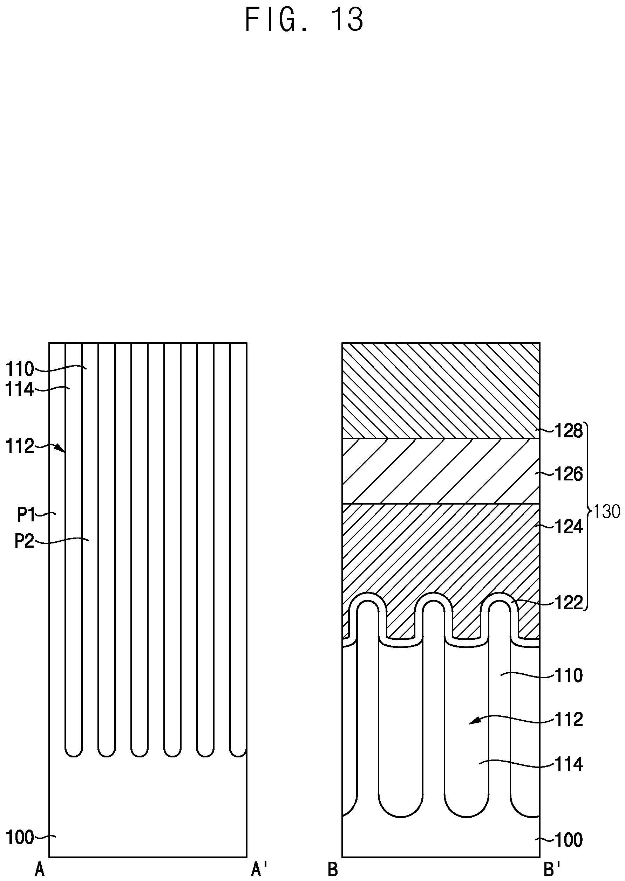

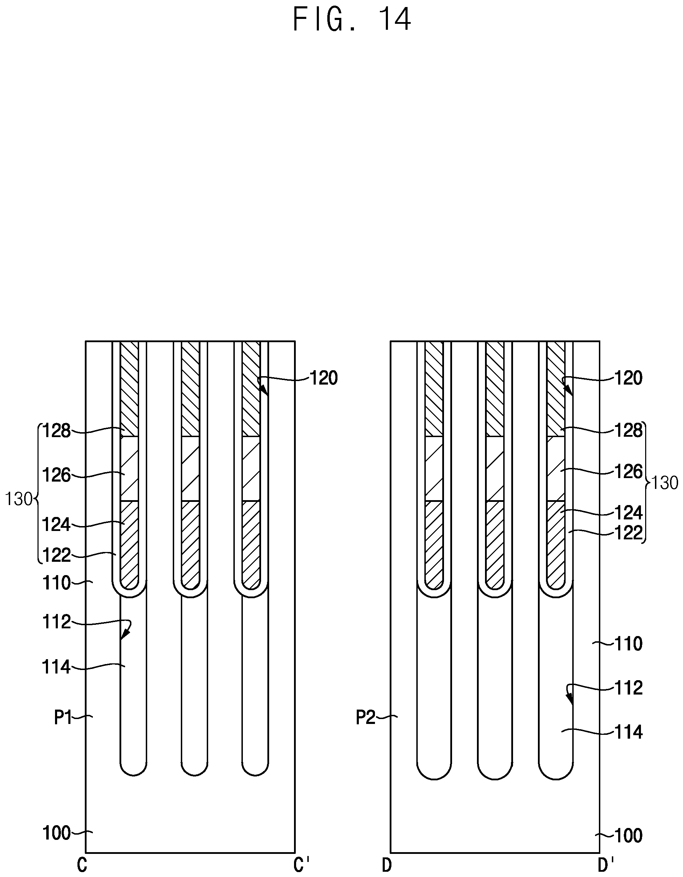

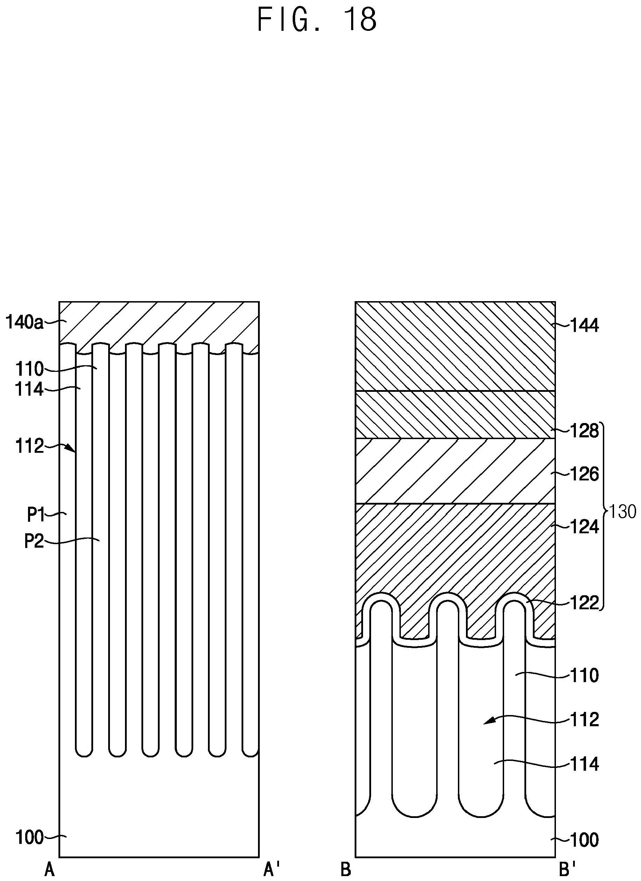

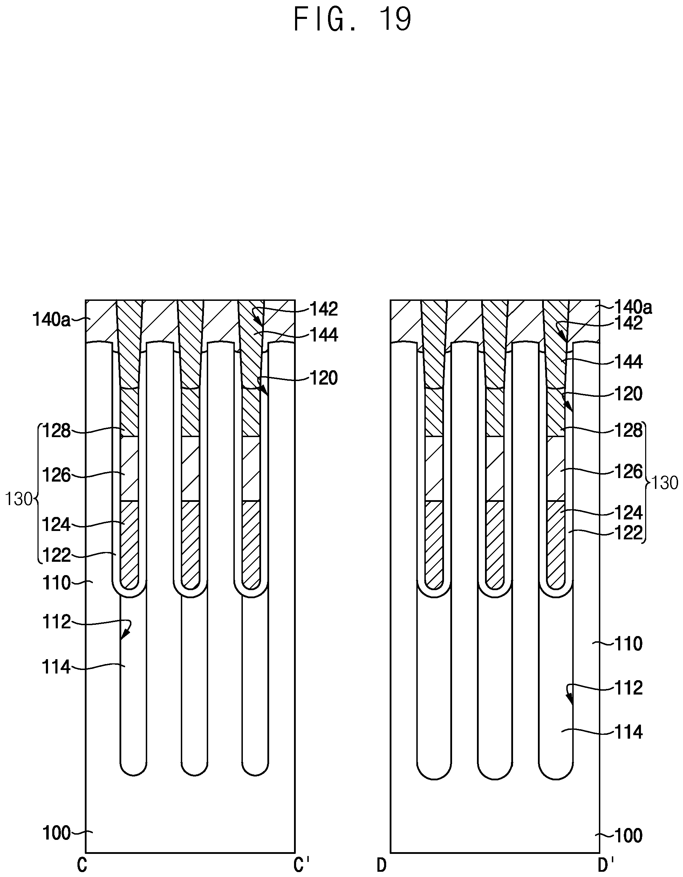

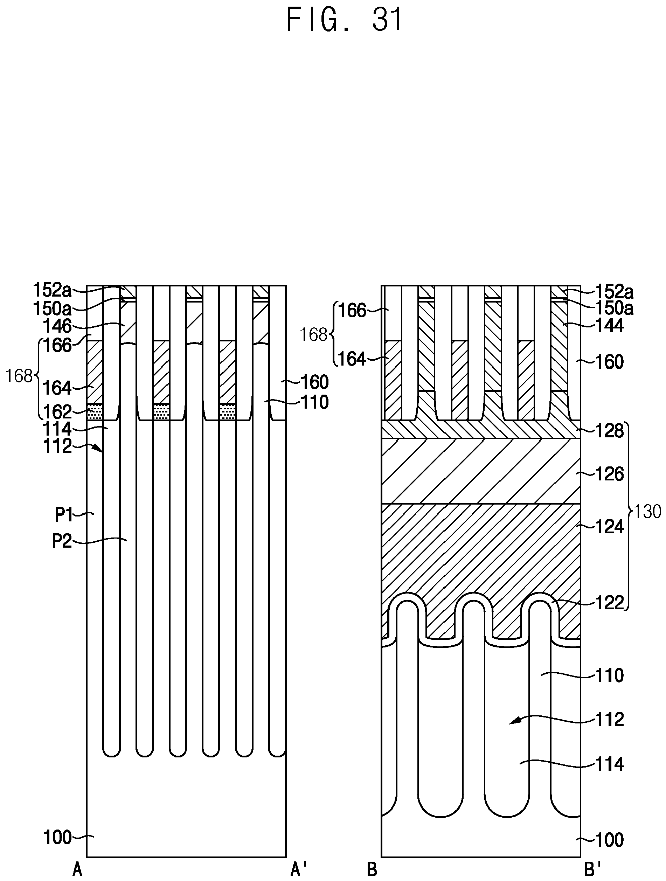

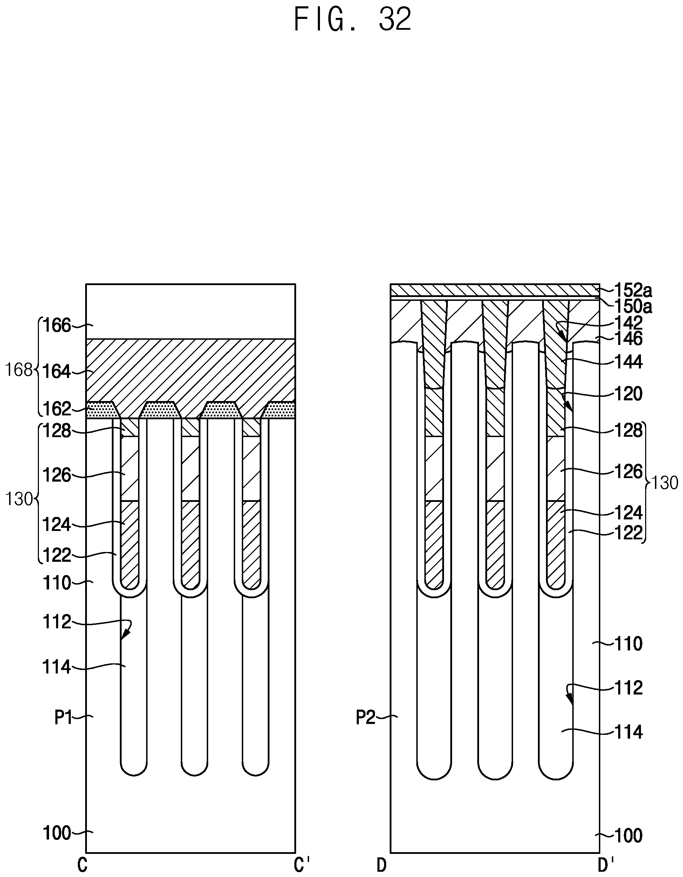

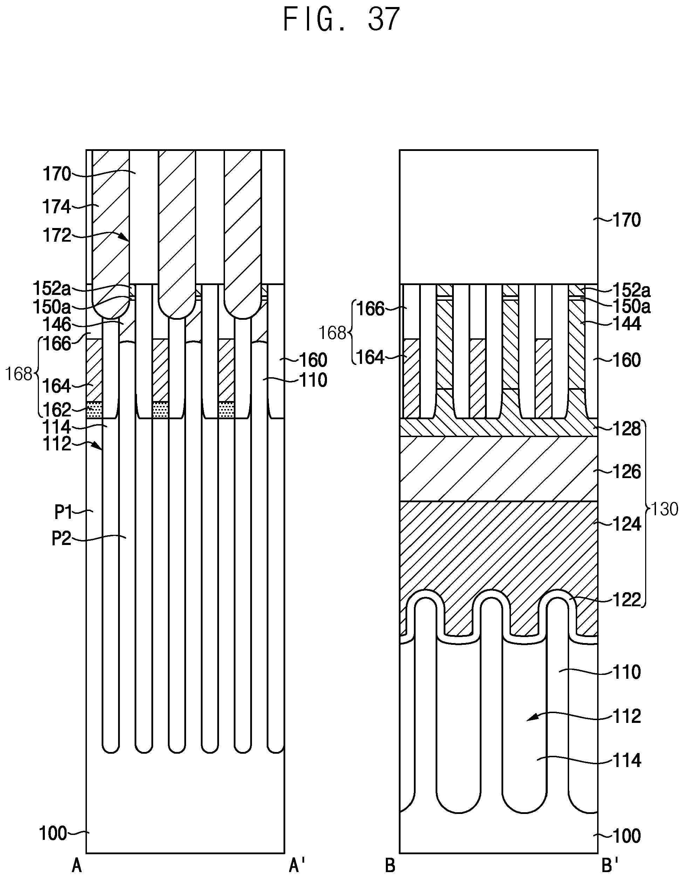

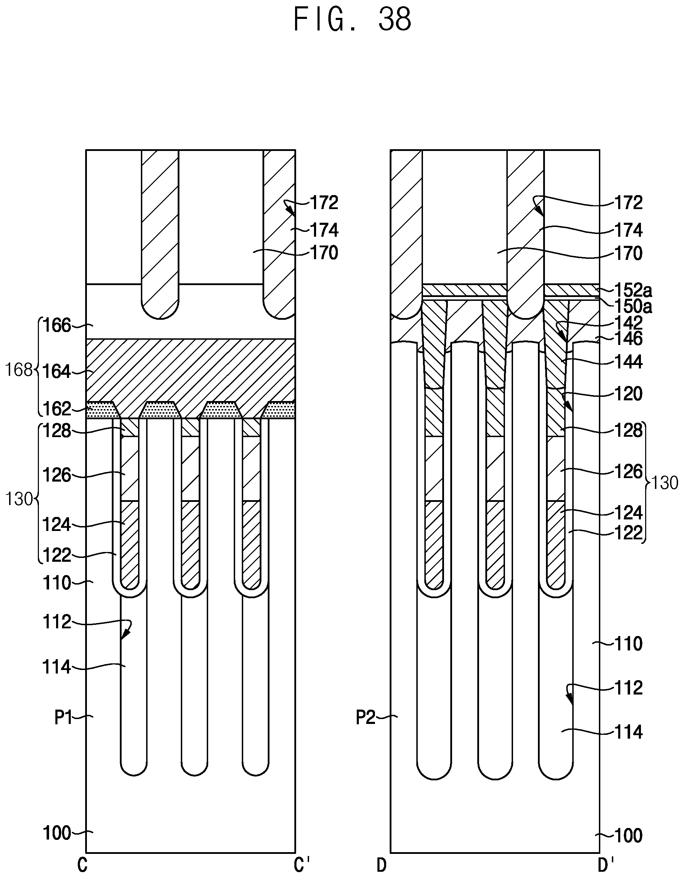

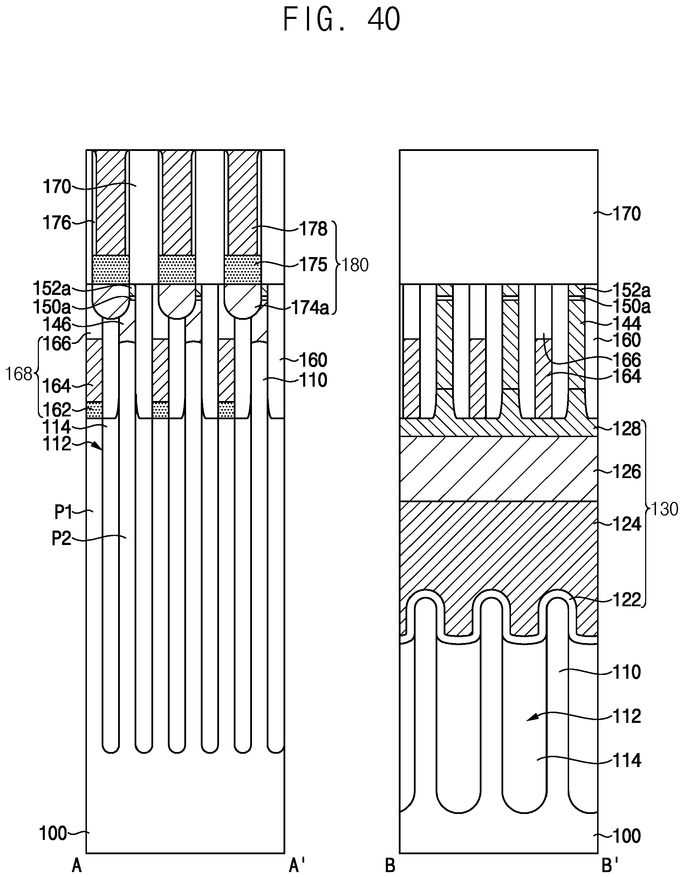

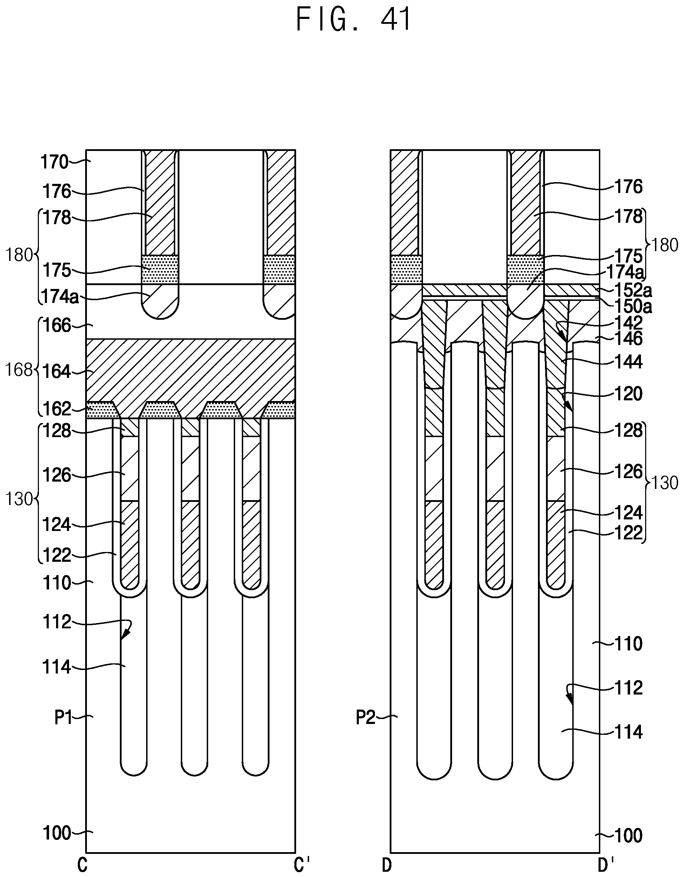

FIGS. 6 to 43 are plan views and cross-sectional views illustrating an example of a method of manufacturing a semiconductor device.

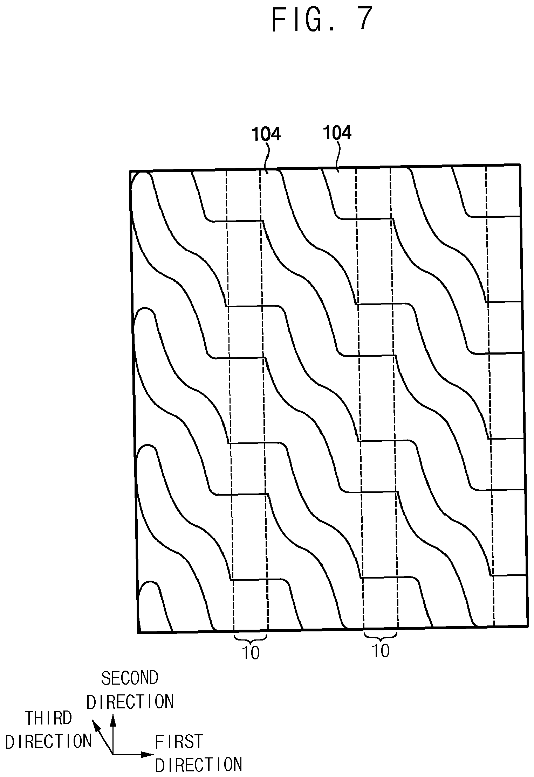

Referring to FIGS. 6 and 7, preliminary mask patterns 104 for forming active patterns may be formed on a substrate.

Each of the preliminary mask patterns 104 may extend in the third direction that is oblique with respect to the first direction. The preliminary mask patterns may be repeatedly arranged to be spaced apart from each other.

In some implementations, the preliminary mask pattern 104 may be formed by a double patterning process. As shown in FIG. 6, a first mold mask pattern 102 may be formed on the substrate. The preliminary mask patterns 104 may be formed on a sidewall of the first mold mask pattern 102. The preliminary mask patterns 104 may have a spacer shape. Thereafter, as shown in FIG. 7, the first mold mask pattern 102 may be removed to form preliminary mask patterns 104 spaced apart from each other.

In some implementations, the preliminary mask patterns 104 may be formed by a patterning process including a single photo process and a single etching process. In some implementations, the preliminary mask patterns 104 may be formed by a quadruple patterning process in which twice double patterning processes are performed.

The preliminary mask patterns 104 may be designed in various shapes to form the active patterns having a target shape.

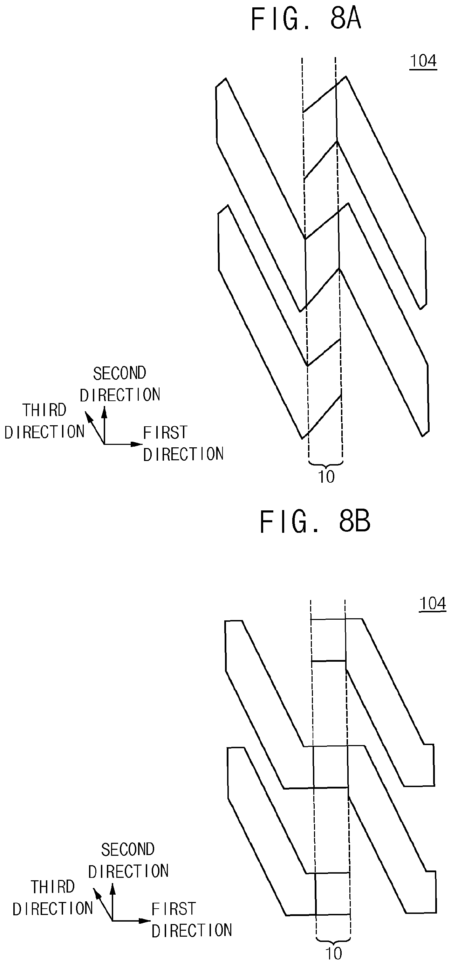

FIGS. 8A to 8G illustrates plan views of various types of preliminary mask patterns. In FIGS. 8A to 8G, a dotted line indicates a portion for cutting.

In some implementations, as shown in FIG. 8A, each of the preliminary mask patterns 104 may have a portion extending in the third direction and a bent portion bent in a fourth direction perpendicular to the third direction. Each of the preliminary mask patterns 104 may extend such that the portion extending in the third direction and the bent portion bent in the fourth direction may be repeatedly and alternately arranged. The bent portion bent in the fourth direction of the preliminary mask patterns 104 may correspond to a cutting portion in a subsequent process.

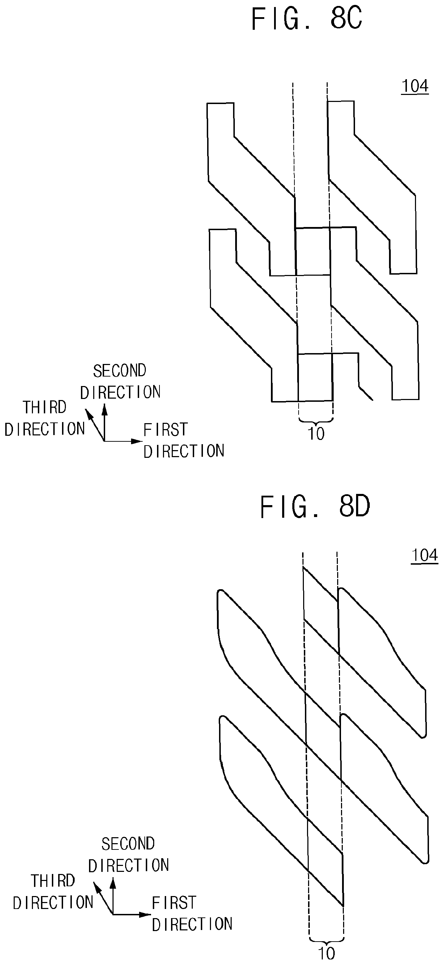

In some implementations, as shown in FIGS. 8B and 8C, the preliminary mask patterns 104 may have a portion extending in the third direction and a bent portion bent in the first direction. The preliminary mask patterns 104 may extend such that the portion extending in the third direction and the bent portion bent in the first direction may be repeatedly and alternately arranged. The bent portion that is bent in the first direction of the preliminary mask patterns 104 may correspond to a cutting portion in a subsequent process.

In some implementations, as shown in FIG. 8D, the preliminary mask patterns 104 may have a portion extending in the third direction and a protruding portion protruding from a side of the portion extending in the third direction. The protruding portion may be regularly and repeatedly disposed.

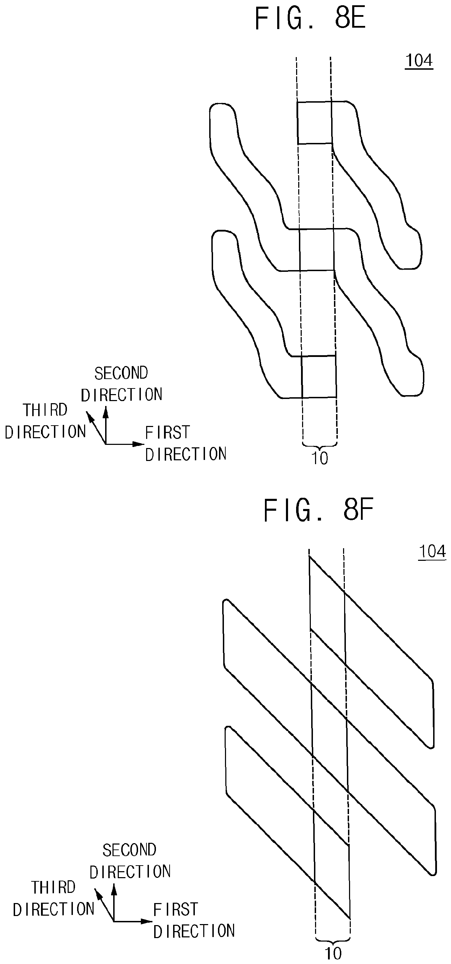

In some implementations, as shown in FIGS. 8E and 7, the preliminary mask patterns 104 may include a portion extending in the third direction and a portion extending in the first direction. Both sides of the portion extending in the third direction may curve. The portion extending in the first direction may correspond to a cutting portion in a subsequent process.

In some implementations, as shown in FIG. 8F, each of the preliminary mask patterns may have a straight shape extending in the third direction.

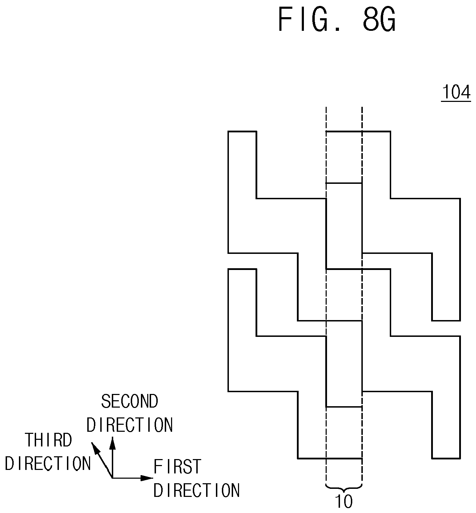

In some implementations, as shown in FIG. 8G, the preliminary mask patterns include a portion extending in the first direction and a portion extending in the second direction. The preliminary mask patterns 104 may extend such that the portion extending in the first direction and the portion extending in the second direction may be repeatedly and alternately arranged. Some of the portion extending in the first direction may correspond to a cutting portion in a subsequent process.

Hereinafter, processes may be described using the preliminary mask pattern 104 shown in FIG. 7 as an example. However, even though the preliminary mask patterns 104 having different shapes may be used, subsequent processes may be performed in the same manner.

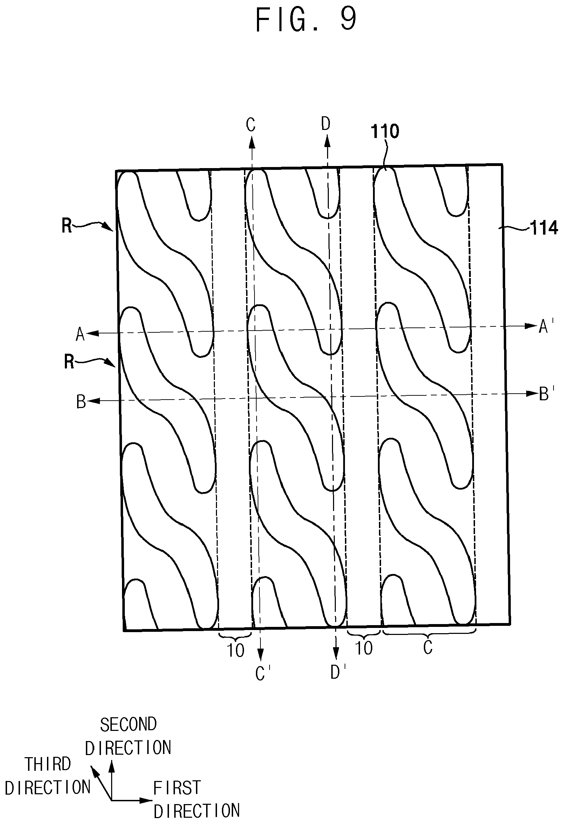

Referring to FIGS. 9 to 11, the preliminary mask pattern 104 may be etched in the second direction for cutting of the preliminary mask pattern 104 to form a mask pattern. An etched portion (i.e., a cutting portion 10) may have a line shape extending in the second direction.

The substrate 100 may be etched using the mask pattern as an etch mask to form active patterns 110. Particularly, the preliminary mask pattern 104 may be etched in the second direction, the preliminary mask pattern 104 may be separated to form the mask pattern. The active patterns 110 may be formed using the mask pattern as the etch mask. Therefore, the active patterns 110 having high arrangement density may be formed by the following process. Additionally, a device isolation trench 112 may be formed between the active patterns 110.

In some implementations, the substrate 100 may be etched using the preliminary mask pattern 104 as an etch mask to form a preliminary active pattern. Thereafter, the preliminary active pattern may be etched in the second direction, and thus the preliminary active pattern may be separated to form the active patterns 110.

The active patterns 110 may have a target shape. The active patterns 110 may not be limited to the shape and arrangement shown in FIG. 9. For example, the active patterns may have any one of the shapes and arrangements shown in FIGS. 5A to 5G.

By the above process, the active patterns 110 with the third direction as a longitudinal direction may be formed. The active patterns 110 arranged side by side in the first direction may form an active row R. Additionally, the active patterns 110 arranged side by side in the second direction perpendicular to the first direction may form an active column C. Accordingly, the active rows R and the active columns C may form an active array.

Identical active columns C may be repeatedly arranged in the first direction. In some implementations, adjacent active columns C may be disposed symmetrically with respect to a straight line extending in the second direction. The active patterns 110 included in the active column C may be arranged in the second direction.

At least a portion of the active patterns 110 included in the even-numbered active row R may be disposed between adjacent active patterns 110 included in the odd-numbered active row R adjacent the even-numbered active row R.

Thereafter, a device isolation pattern 114 may be formed to fill the device isolation trench 112. The device isolation pattern 114 may include an insulation material, e.g., silicon oxide.

The process for forming the device isolation pattern 114 may include forming an insulation layer on the active patterns 110 to fill the device isolation trench 112 and planarizing the insulation layer so as so to expose an upper surface of the active pattern 110. The planarization process may include a chemical mechanical polishing process.

Referring to FIGS. 12 to 14, central portions of the active patterns 110 and the device isolation pattern 114 may be partially etched to form a first recess 120 extending in the first direction. One active pattern 110 may include one first recess 120. Accordingly, one active pattern 110 may be divided, by the first recess 120, into a first portion P1 corresponding to a portion above the first recess 120 in a plan view and a second portion P2 corresponding to a portion below the first recess 120 in the plan view. In the active pattern 110, a portion adjacent to the first sidewall of the first recess 120 may be the first portion P1, and a portion adjacent the second sidewall of the first recess 120 may be the second portion P2.

Each of the first recesses 120 may extend in the first direction to cross the central portions of the plurality of active patterns 110 included in the same active row R. The first recesses 120 may be spaced apart in the second direction.

In some implementations, distances d1 between neighboring first recesses 120 in the second direction may be substantially equal to each other. In this case, since the arrangement density of the first recesses 120 is uniform, the first recesses 120 may be easily formed.

In some implementations, an upper surface of the device isolation pattern 114 exposed by a bottom of the first recess 120 may be lower than an upper surface of the active pattern 110 exposed by the bottom of the first recess 120. Therefore, an upper portion (e.g., an upper sidewall and an upper surface) of the active pattern 110 disposed above the upper surface of the device isolation pattern 114 may be exposed in the first recess 120. Accordingly, the upper portion of the active pattern 110 exposed by the first recess 120 may serve as an active fin for forming a fin field effect transistor.

Thereafter, a gate structure 130 may be formed in the first recess 120.

Particularly, a gate insulation layer may be conformally formed on the bottom and sidewalls of the first recess 120. A first gate electrode layer may be formed on the gate insulation layer, and an upper portion of the first gate electrode layer may be removed to form a first gate pattern 124 in a lower portion of the first recess 120. A second gate electrode layer may be formed on the first gate pattern 124 and the gate insulation layer, and then an upper portion of the second gate electrode layer may be removed to form a second gate pattern 126 in the first recess 120. A gate mask layer may be formed on the gate insulation layer and the second gate pattern 126. The gate mask layer may be planarized until the upper surfaces of the active patterns 110 and the device isolation pattern 114 may be exposed to form a gate structure 130 in the first recess 120. The gate structure may include the gate insulation pattern 122, the first gate pattern 124, the second gate pattern 126, and the gate mask 128 stacked.

The gate structure 130 may extend in the first direction, and a plurality of gate structures may be spaced apart from each other in the second direction.

In some implementations, the gate insulation pattern 122 may be formed on the upper surface and the sidewall of the active pattern 110 in the first recess 120. Accordingly, the gate structure 130 may serve as a gate of the fin field effect transistor.

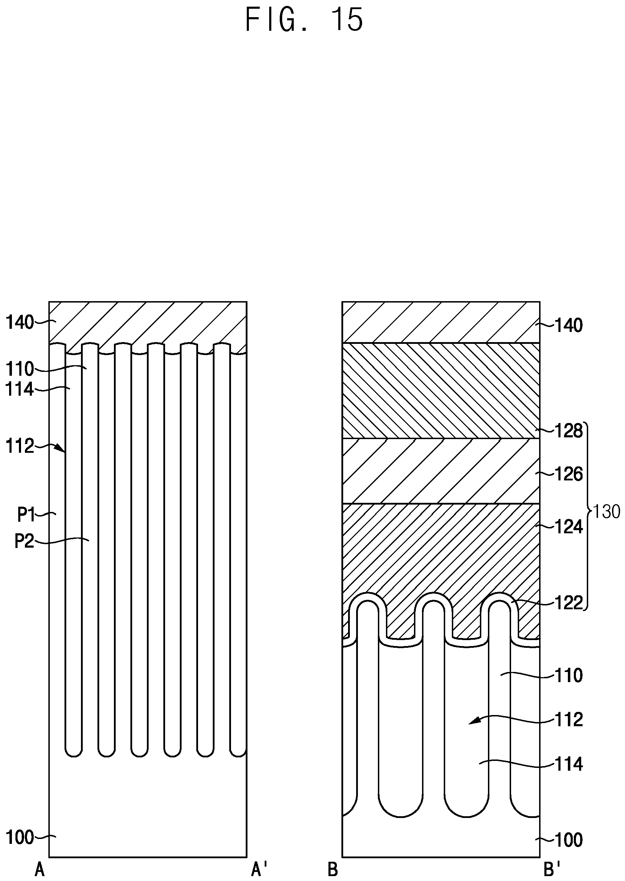

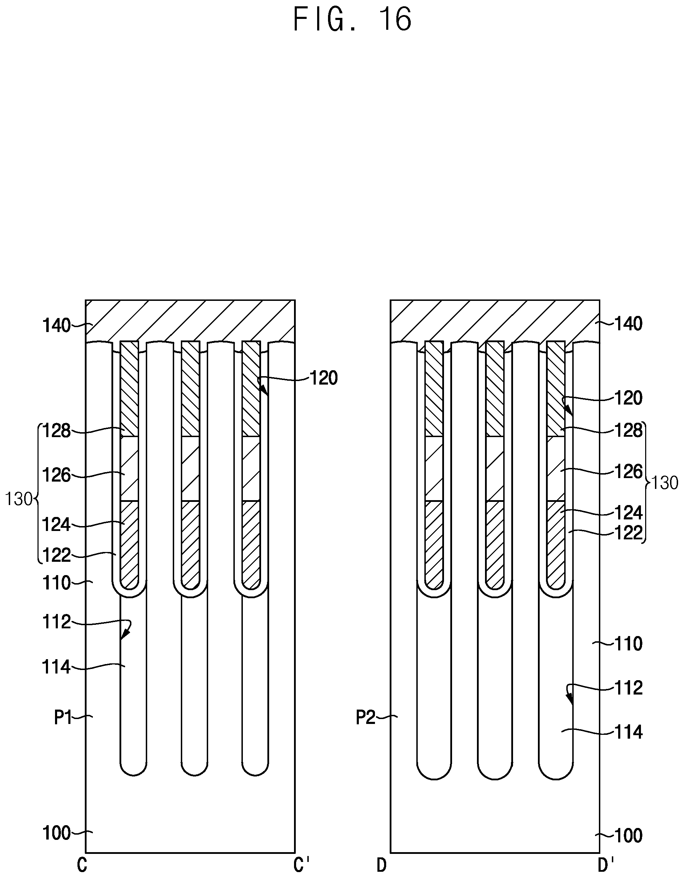

Referring to FIGS. 15 and 16, a cleaning process may be performed to remove a native oxide layer on the surface of the active pattern 110 adjacent both sides of the gate structure 130. When the cleaning process is performed, upper portions of the device isolation pattern 114 and the gate insulation pattern 122 may be removed. Accordingly, the active pattern 110 may protrude from the device isolation pattern 114, and the upper surface and upper sidewalls of the active pattern 110 may be exposed. Therefore, an exposed area of the active pattern 110 may be increased.

Thereafter, a first conductive layer 140 may be formed to cover the device isolation pattern 114, gate structure 130, and active pattern 110. The first conductive layer 140 may directly contact the active pattern 110 adjacent to both sides of the gate structure 130.

The first conductive layer 140 may include polysilicon doped with impurities. The impurities may include N-type impurities. The impurities may diffuse into the active pattern 110 to form first and second impurity regions at the active pattern 110 adjacent to both sides of the gate structure 130.

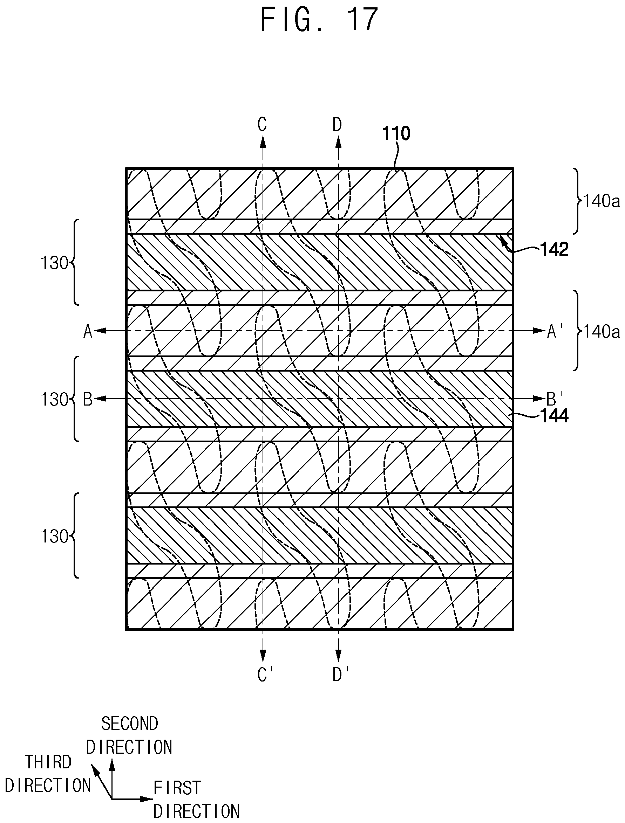

Referring to FIGS. 17 to 19, an etch mask may be formed on the first conductive layer 140 to selectively expose the central portions of the active patterns 110. The etch mask may have a line shape extending in the first direction while covering at least the first and second portions P1 and P2 of the active pattern 110.

In some implementations, an exposed portion of the etch mask may overlap the gate mask 128 of the gate structure 130.

A portion of the first conductive layer 140 may be etched using the etch mask to form a first opening 142 exposing an upper portion of the gate mask 128 of the gate structure 130 on the central of the active patterns 110 and extending in the first direction. In the etching process, the upper portion of the gate mask 128 may be partially removed.

The first conductive layer 140 may be transformed into first conductive patterns 140a extending in the first direction by forming the first opening 142. Each of the first conductive patterns 140a may extend in the first direction and may contact the first and second portions P1 and P2 of the active pattern 110. The first conductive patterns 140a may be spaced apart from each other in the second direction. In some implementations, distances between adjacent first conductive patterns 140a in the second direction may be substantially equal to each other.

Thereafter, a first insulation layer may be formed on the first conductive pattern 140a and the gate mask 128 to fill the first opening 142. The first insulation layer may be planarized until an upper surface of the first conductive pattern 140a is exposed to form a first insulation pattern 144 filling the first opening 142. The first insulation pattern 144 may include a same material as a material of the gate mask 128. Accordingly, the gate mask 128 and the first insulation pattern 144 may be merged into one layer. The first insulation pattern 144 may include silicon nitride.

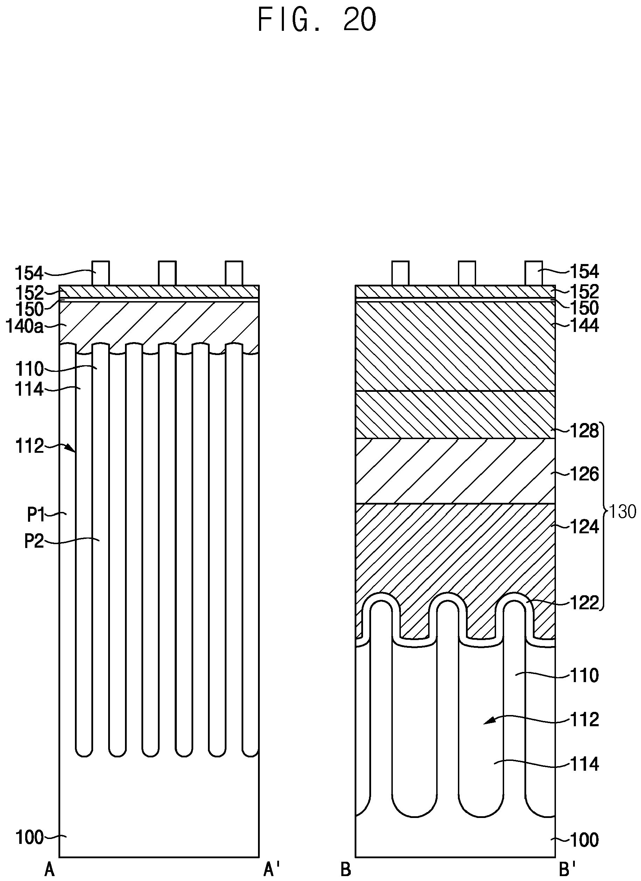

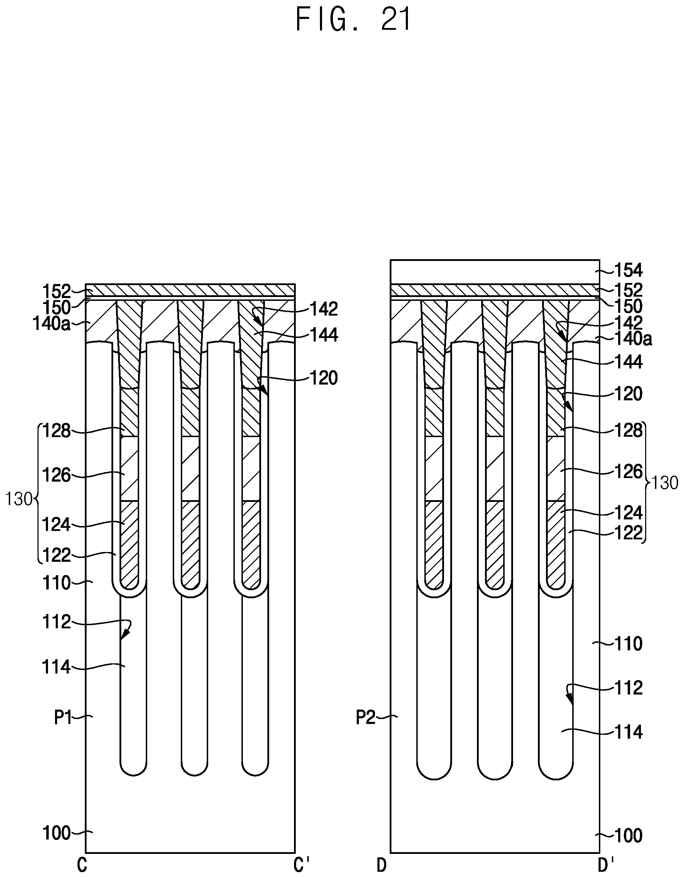

Referring to FIGS. 20 and 21, a first buffer layer 150 may be formed on the first conductive pattern 140a and the first insulation pattern 144. The first buffer layer 150 may cover the first conductive pattern 140a and the first insulation pattern 144. A second buffer layer 152 may be formed on the first buffer layer 150.

The first buffer layer 150 and the second buffer layer 152 may include an insulation material. The first buffer layer 150 may include a material having a high etch selectivity with respect to a material of the second buffer layer 152. In some implementations, the first buffer layer 150 may include silicon oxide, and the second buffer layer 152 may include silicon nitride. The second buffer layer 152 may be formed to have a thickness greater than a thickness of the first buffer layer 150.

An etch mask 154 having a liner shape extending in the second direction may be formed on the second buffer layer 152 to cover the second portion P2 of the active pattern 110. The etch mask 154 may expose the first portion P1 of the active pattern 110 and a portion of the gate structure 130.

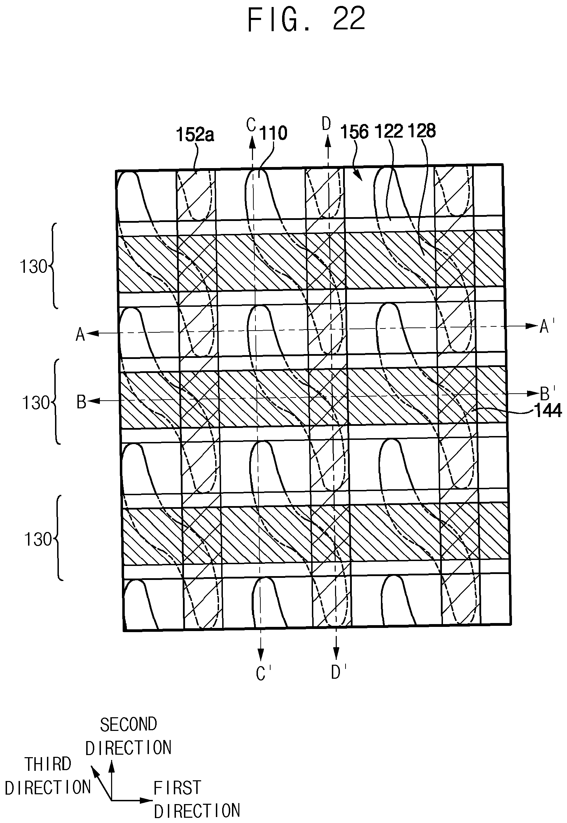

Referring to FIGS. 22 to 25, the second buffer layer 152, the first buffer layer 150, the first conductive pattern 140a, and the first insulation pattern 144 may be etched using the etch mask 154. Subsequently, upper portions of the device isolation pattern 114, the active pattern 110, and the gate mask 128 may be etched to form a second opening 156.

The second opening 156 may extend in the second direction while exposing the first portion P1 of each of active patterns 110. The first portions P1 of the active patterns 110, the device isolation pattern 114, and the gate masks 128 may be exposed by a bottom of the second opening 156. The upper surface of the first portion P1 of the active pattern 110 exposed by the bottom of the second opening 156 may be lower than the upper surface of the second portion P2 of the active pattern 110.

The first conductive pattern 140a may be patterned to form first contact plugs 146 positioned at both sides of the second openings 156. Additionally, the first and second buffer layers 150 and 152 may be patterned to form first and second buffer layer patterns 150a and 152a, respectively.

The first contact plugs 146 may have an isolated shape and may contact the second portions P2 of the active patterns 110, respectively. That is, the first contact plug 146 may be formed by cutting the first conductive pattern 140a in the second direction and thus may have the isolated shape. A first insulation pattern 144 may remain between the first contact plugs 146 in the second direction.

The first and second buffer layer patterns 150a and 152a may extend in the second direction. The first and second buffer layer patterns 150a and 152a may cover the first contact plug 146 and the first insulation pattern 144.

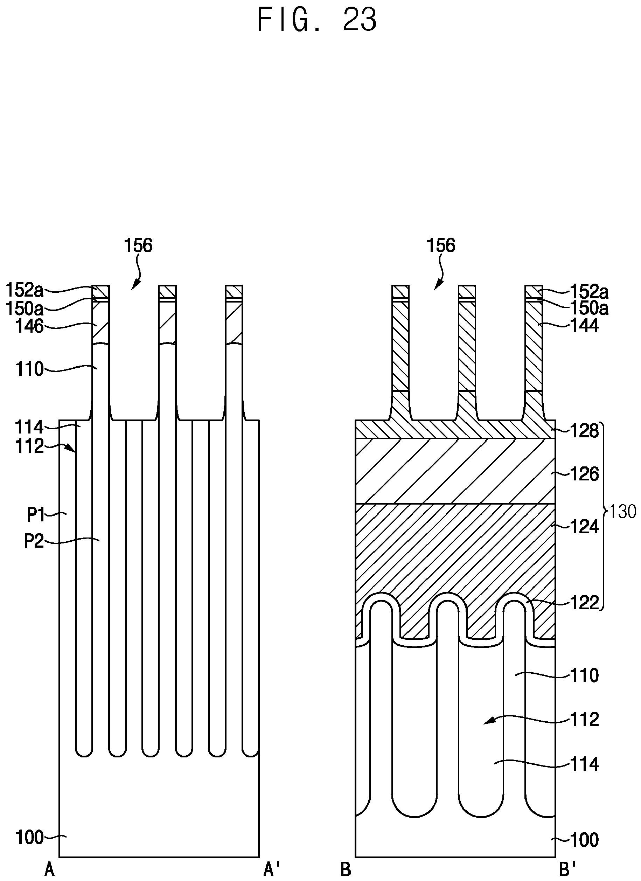

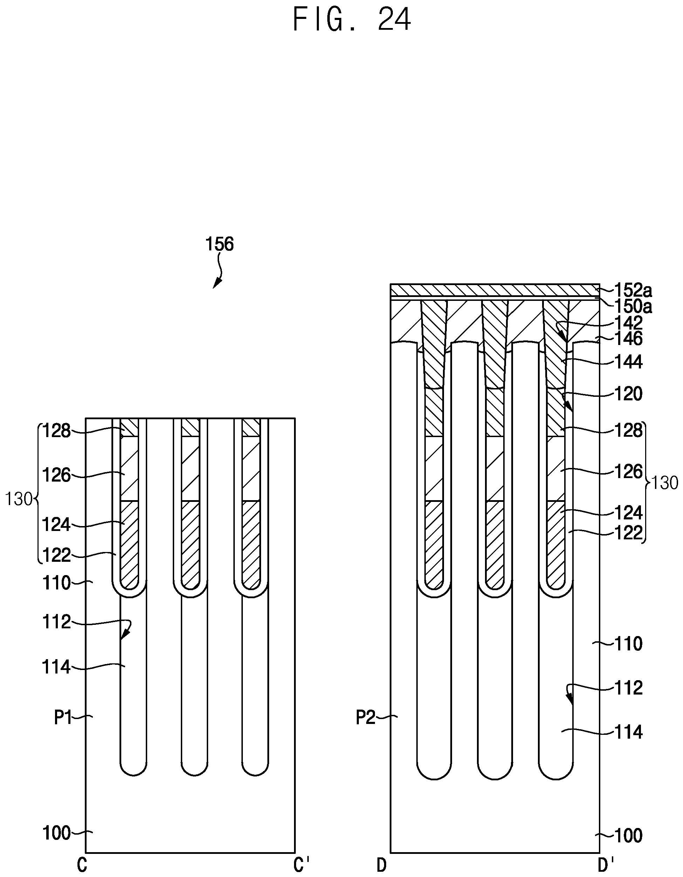

In some implementations, the device isolation pattern 114, the active pattern 110, and the gate mask 128 may be etched at substantially the same etch rate. In this case, as shown in FIGS. 23 and 24, upper surfaces of the first portion P1 of the active patterns 110 and of the gate mask 128 exposed by the bottom of the second opening 156 may be substantially coplanar with each other.

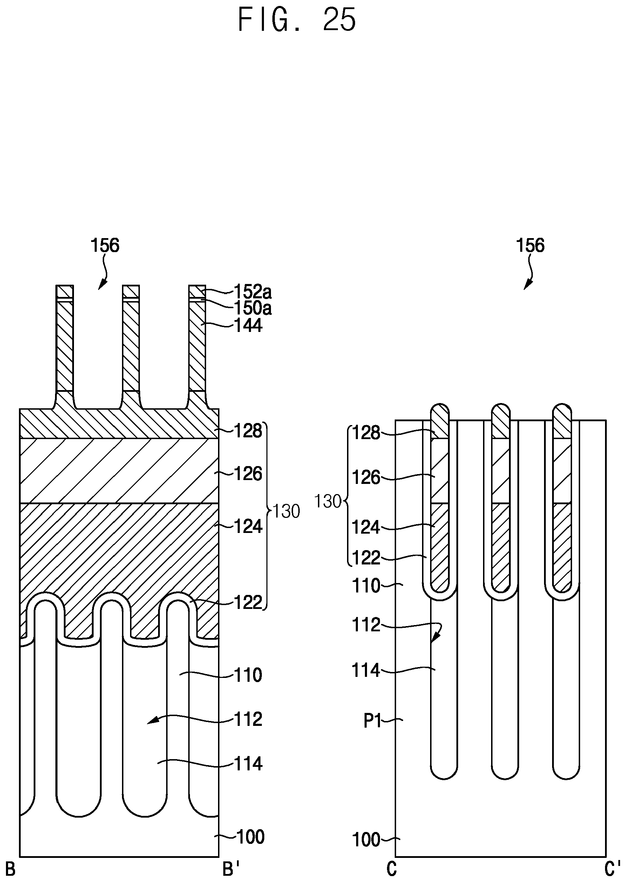

In some implementations, the gate mask 128 may be etched to have an etch rate lower than etch rates of the device isolation pattern 114 and the active pattern 110. In this case, as shown in FIG. 25, the first portion P1 of the active patterns 110 exposed by the bottom of the second opening 156 may be lower than an upper surface of the gate mask 128 exposed by the bottom of the second opening 156. The gate mask 128 exposed by the bottom of the second opening 156 may protrude from the first portion P1 of the active patterns 110 exposed by the bottom of the second opening 156.

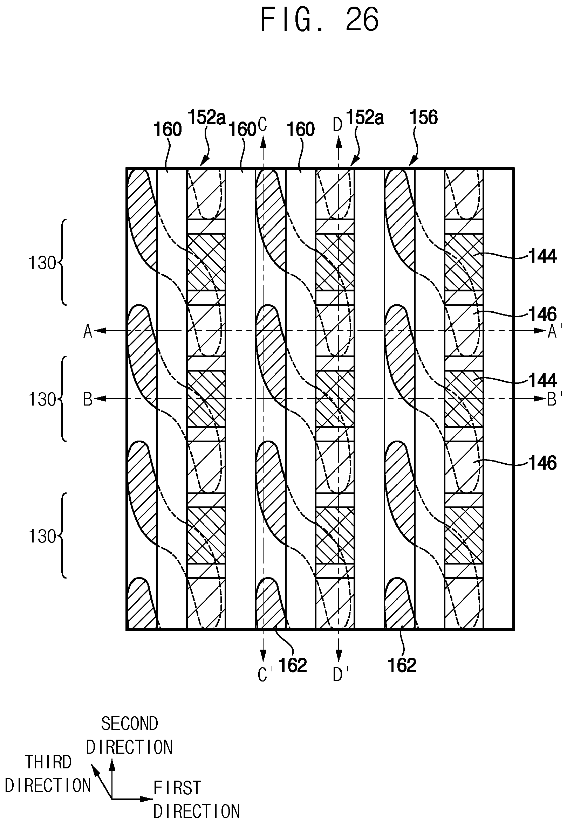

Referring to FIGS. 26 to 29, an insulation spacer layer may be conformally formed on surfaces of the second buffer layer pattern 152a and the second opening 156. The insulation spacer layer may include silicon oxide.

The insulation spacer layer may be anisotropically etched to form an insulation spacer 160 on the sidewall of the second opening 156. The insulation spacer 160 may be formed on the first contact plug 146, the device isolation pattern 114, and the first and second buffer layer patterns 150a and 152a corresponding to the sidewall of the second opening 156. As the insulation spacer 160 is formed, an inner width of the second opening 156 may decrease. The first portion P1 of the active pattern 110 and the gate mask 128 may be exposed by the bottom of the second opening 156.

A first silicon layer may be formed on at least the first portion P1 of the active pattern 110 exposed by the bottom of the second opening 156.

The first silicon layer may be formed so as to increase an area of silicon contacting a first metal layer in a subsequent heat treatment process for a silicidation. However, in some implementations, the process of forming the first silicon layer may be omitted.

The first metal layer may be formed on the first silicon layer, and the heat treatment process may be performed to form a first metal silicide pattern 162 on at least the active pattern 110 in the second opening 156. The first metal silicide pattern 162 may be formed by reacting the first silicon layer and the first metal layer with each other. In some implementations, during the process for forming the first metal silicide pattern 162, all of the first silicon layer may be reacted to remain only the first metal silicide pattern 162 on the active pattern 110.

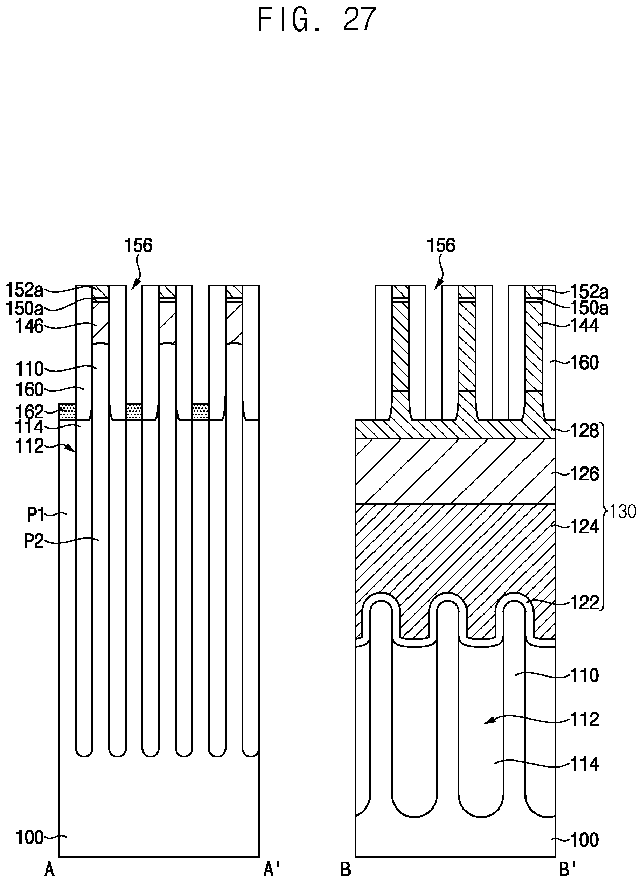

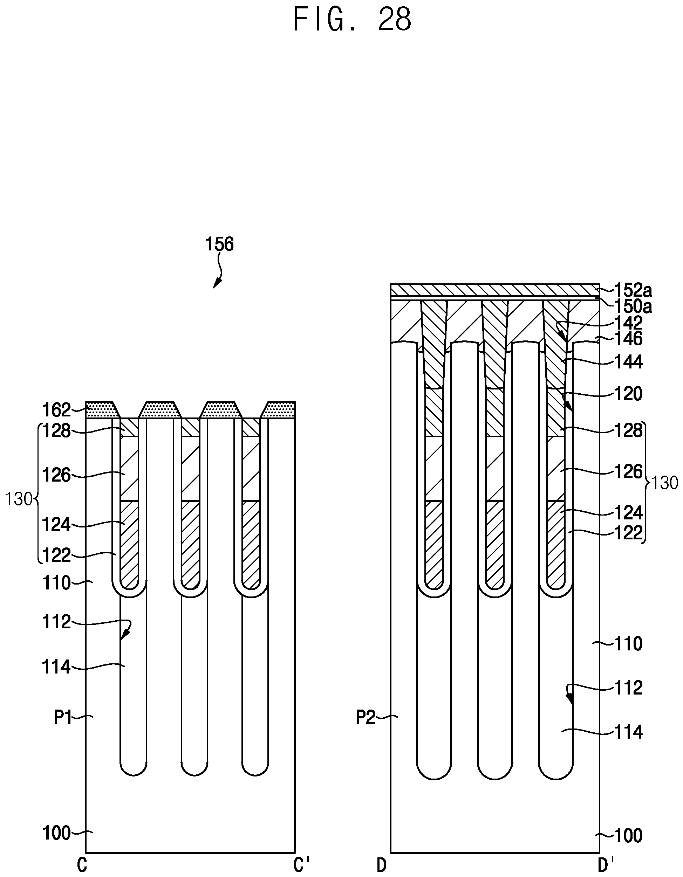

In some implementations, the first silicon layer may be formed by a selective epitaxial growth process. In this case, as shown in FIGS. 27 and 28, the first silicon layer may be formed only on an exposed first portion P1 of the active pattern 110. Accordingly, the first metal silicide pattern 162 may be formed only on the exposed first portion P1 of the active pattern 110. Accordingly, the first metal silicide patterns 162 in the second opening 156 may be spaced apart from each other in the second direction.

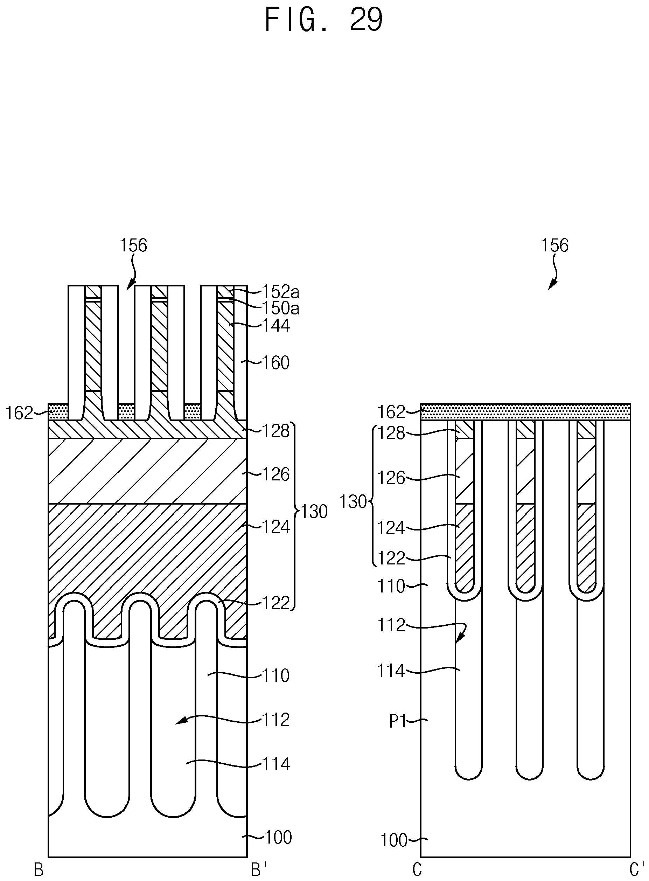

In some implementations, the first silicon layer may be formed on the first portion P1 of the active pattern 110 and the upper surface of the gate mask 128 adjacent thereto. The first silicon layer may be formed by depositing a polysilicon layer and etching back of the polysilicon layer. The first silicon layer may be formed on an entire bottom of the second opening 156. Therefore, as shown in FIG. 29, the first metal silicide pattern 162 may be formed on the exposed the first portion P1 of the active pattern 110 and the upper surface of the gate mask 128 adjacent thereto. Accordingly, the first metal silicide pattern 162 formed in the second opening 156 may extend in the second direction.

Hereinafter, processes including the first metal silicide pattern 162 formed only on the exposed first portion P1 of the active pattern 110 will be described. However, the first metal silicide pattern may not be limited thereto, the first metal silicide pattern may be formed on the exposed first portion P1 of the active pattern 110 and the upper surface of the gate mask 128 adjacent thereto. In this case, the same subsequent process may be performed.

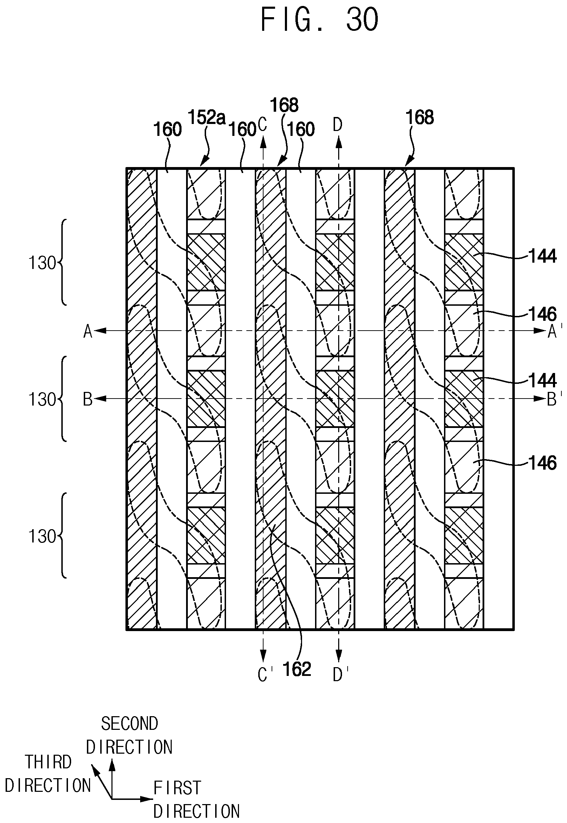

Referring to FIGS. 30 to 32, a second conductive layer may be formed on the first metal silicide pattern 162, the gate mask 128, the second buffer layer pattern 152a, and the insulation spacer 160 to fill the second opening 156. The second conductive layer may be etched back so that the second conductive layer may remain only inside the second opening 156 to form a bit line pattern 164.

In some implementations, the bit line pattern 164 may include a metal pattern. In some implementations, the bit line pattern 164 may have a structure in which a barrier metal pattern and a metal pattern are stacked.

In some implementations, an uppermost surface of the bit line pattern 164 may be lower than an upper surface of the first contact plug 146.

The bit line pattern 164 may extend in the second direction and may be electrically connected to the first portions P1 of the active patterns 110 in the second opening 156. The bit line pattern 164 may be formed by a damascene process. Therefore, patterning defects of the bit line pattern 164 may be decreased, compared to forming the bit line pattern in an embossed process. Further, even though a line width of the bit line pattern is decreased, the patterning defects of the bit line pattern 164 may be decreased.

A second insulation layer may be formed on the bit line pattern 164, the second buffer layer pattern 152a, and the insulation spacer 160 to fill the second opening 156. The second insulation layer may include silicon oxide. Thereafter, the second insulation layer may be planarized until the second insulation layer remains only inside the second opening 156 to form a second insulation pattern 166 filling the second opening 156. The planarization process may include an etch-back or chemical mechanical polishing process. Upper surfaces of the second insulation pattern 166, the insulation spacer 160, and the second buffer layer pattern 152a may be exposed, after the planarization process.

By the above process, a bit line structure 168 including the first metal silicide pattern 162, the bit line pattern 164, and the second insulation pattern 166 may be formed.

In some implementations, the bit line structure 168 contacting on the first portion P1 of the active pattern 110 may include the first metal silicide pattern 162, the bit line pattern 164, and the second insulation pattern 166 stacked. The bit line structure 168 contacting the gate mask may include a bit line pattern 164 and a second insulation pattern 166 stacked.

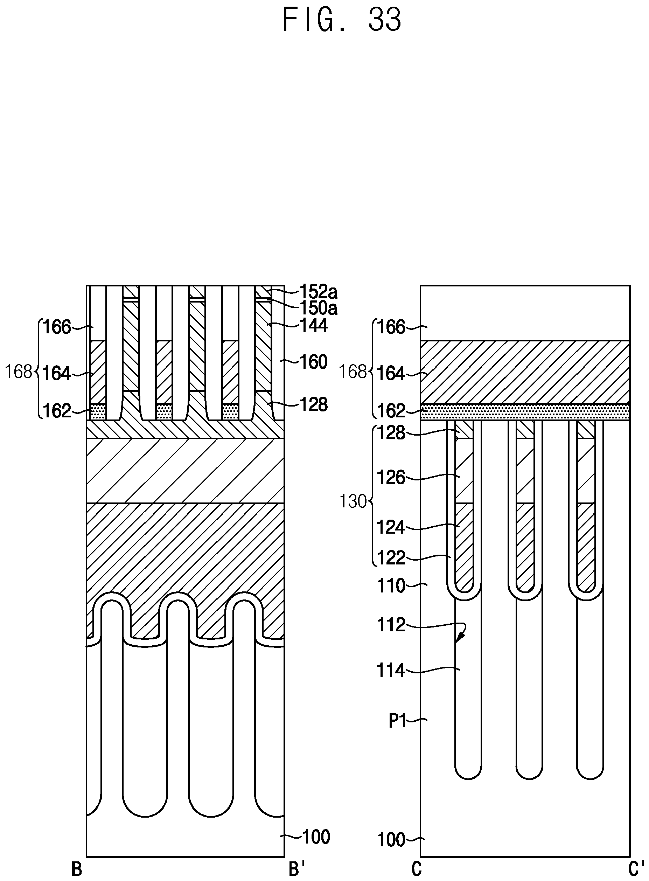

In some implementations, the planarization process may be performed on the structure shown in FIG. 29. In this case, as shown in FIG. 33, the bit line structure 168 contacting on the first portion P1 of the active pattern 110 and the upper surface of the gate mask 128 may include the first metal silicide pattern 162, the bit line pattern 164, and the second insulation pattern 166 stacked.

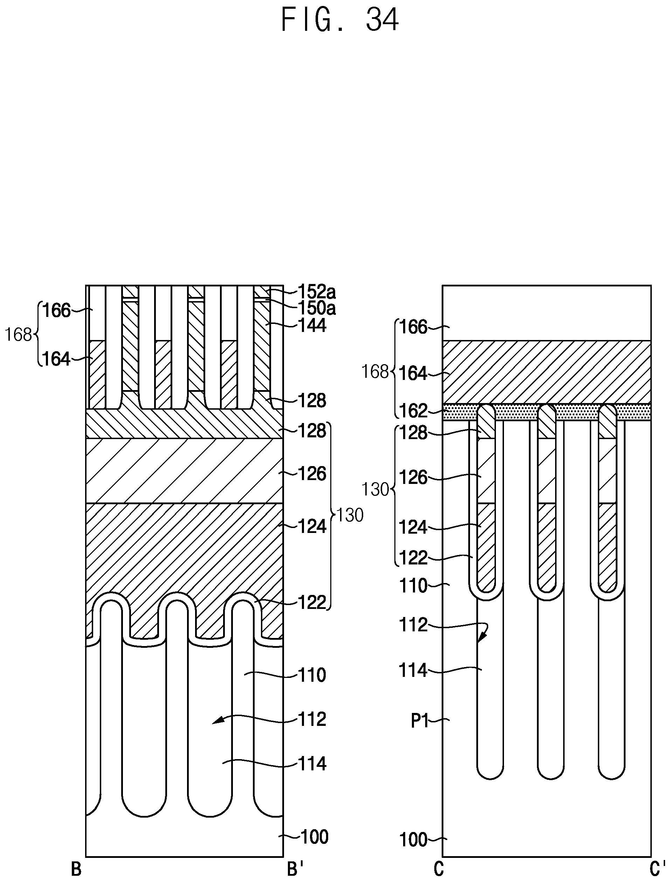

In some implementations, as shown in FIG. 34, the gate mask 128 exposed by the bottom of the second opening 156 may protrude from the first portion P1 of the active patterns 110 exposed by the bottom of the second opening 156. In this case, the first metal silicide pattern 162 may be formed only in a gap between the gate masks 128. That is, the first metal silicide patterns 162 may be spaced apart in the second direction and may be isolated by the gate mask 128 having a protrusion.

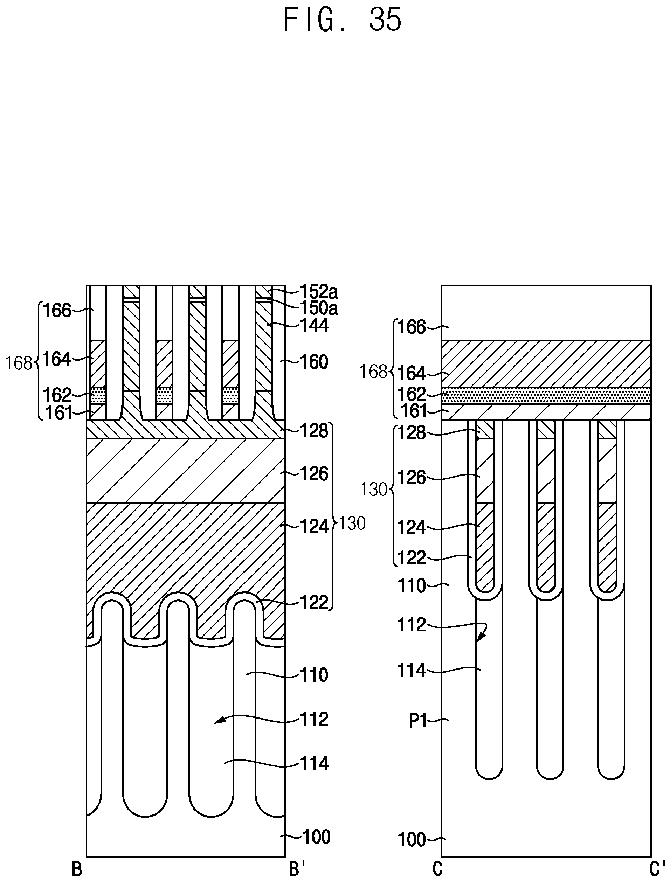

As depicted in FIG. 35, when processes for forming the first metal silicide pattern 162 are performed, the first silicon layer may not be completely reacted and a portion of the first silicon layer may remain. In this case, a stack of a silicon pattern 161 and a first metal silicide pattern 162 may be formed under the bit line pattern 164. The bit line structure 168 contacting the first portion P1 of the active pattern 110 and the upper surface of the gate mask 128 may include the silicon pattern 161, the first metal silicide pattern 162, the bit line pattern 164, and the second insulation pattern 166 stacked.

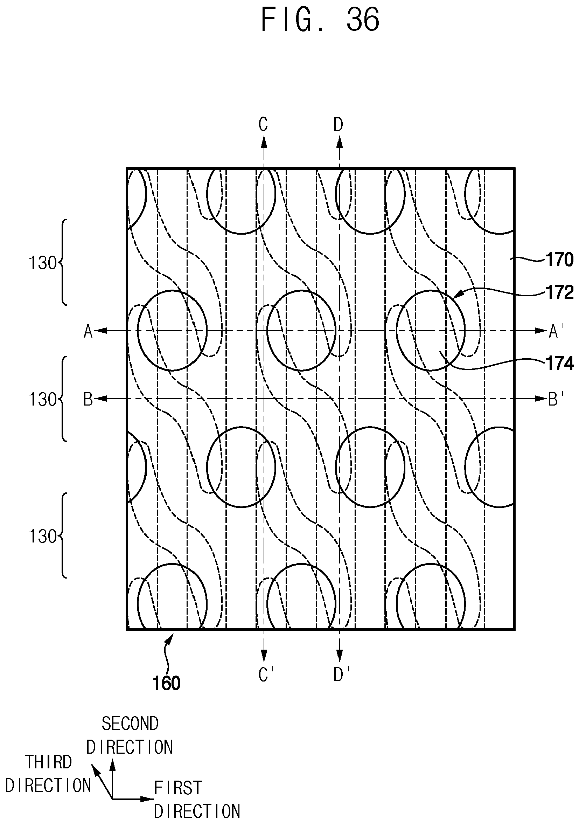

Referring to FIGS. 36 to 38, a first mold layer 170 may be formed on the second insulation pattern 166, the second buffer layer pattern 152a, the first insulation pattern 144, the insulation spacer 160, and the first contact plug 146. A first mold layer 170 may include an insulation material having an etch selectivity with respect to silicon oxide. The first mold layer 170 may include silicon nitride, SiOCN, or SiOC.

The first mold layer 170 may serve as a mold for forming a second contact structure electrically connected to the first contact plug 146.

A portion of the first mold layer 170 may be etched, and the first and second buffer layer patterns 150a and 152a, the second insulation pattern 166, and the insulation spacer 160 below the first mold layer 170 may be etched to form a second contact hole 172 exposing a portion of the upper surface of the first contact plug 146. In some implementations, an upper portion of the first contact plug 146 may also be partially etched by the etching process.

A portion of an upper surface of one first contact plug 146 may be exposed by the bottom of one second contact hole 172.

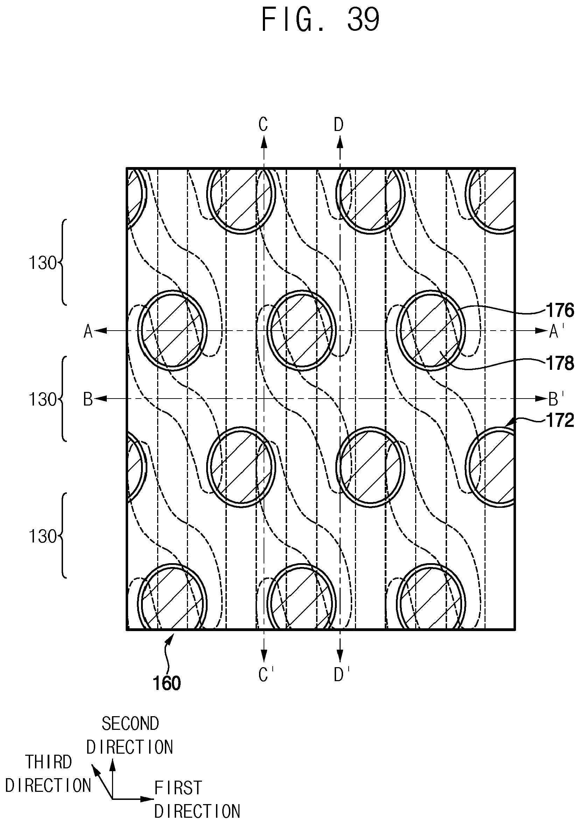

In some implementations, a plurality of second contact holes 172 may be arranged in a honeycomb structure disposed at each vertex of connected hexagons and a central portion of each of the hexagons. For example, see FIG. 39, where the plurality of second contact holes 172 form a hexagonal lattice, with second contact holes 172 located at vertices and the center of each of the connected hexagons in the lattice.

A second silicon layer may be formed on the first mold layer 170 to fill the second contact holes 172, and the second silicon layer may be planarized until an upper surface of the first mold layer 170 is exposed to form a second preliminary silicon pattern 174 in the second contact hole 172. The planarization process may include an etch-back process or a chemical mechanical polishing process.

In some implementations, the second preliminary silicon pattern 174 may include polysilicon doped with impurities. In some implementations, after forming the second silicon layer, a heat treatment process for removing voids may be further performed. The heat treatment process may include laser annealing.

Referring to FIGS. 39 to 41, the second preliminary silicon pattern 174 may be etched back to form a second silicon pattern 174a in a lower portion of the second contact hole 172.

A second metal layer may be formed on the second silicon pattern 174a, and a heat treatment process may be performed to form a second metal silicide pattern 175 on the bottom of the second contact hole 172. The second metal silicide pattern 175 may be formed by reacting the second silicon pattern 174a and the second metal layer with each other.

An inner spacer 176 including insulation material may be formed on a sidewall of the second contact hole 172.

Thereafter, a third metal layer may be formed on the second metal silicide pattern 175 and the first mold layer 170 to fill the second contact hole 172. The third metal layer may be planarized until an upper surface of the first mold layer 170 is exposed to form a second contact plug 178 filling the second contact hole 172.

Accordingly, the second contact plug 178 may be electrically connected to the second portion P2 of the active pattern 110 via the second metal silicide pattern 175, the second silicon pattern 174a, and the first contact plug 146. A stacked structure including the second silicon pattern 174a, the second metal silicide pattern 175, and the second contact plug 178, and contacting the second portion P2 of the active pattern 110 may be referred to as a second contact structure 180.

In some implementations, a plurality of second contact plugs 178 may be arranged in the honeycomb structure disposed d at each vertex of connected hexagons and a central portion of each of the hexagons.

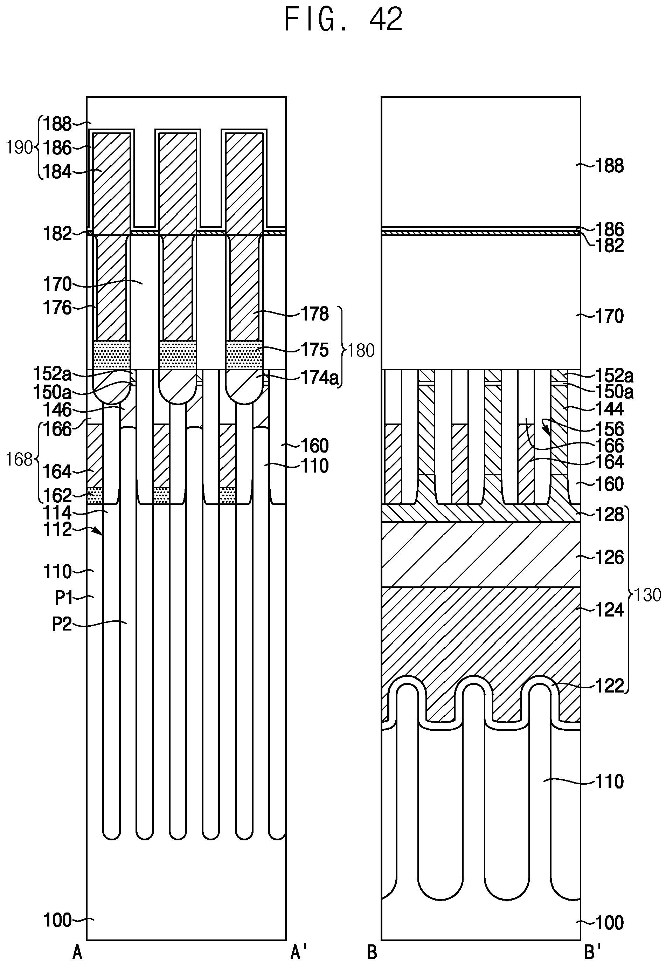

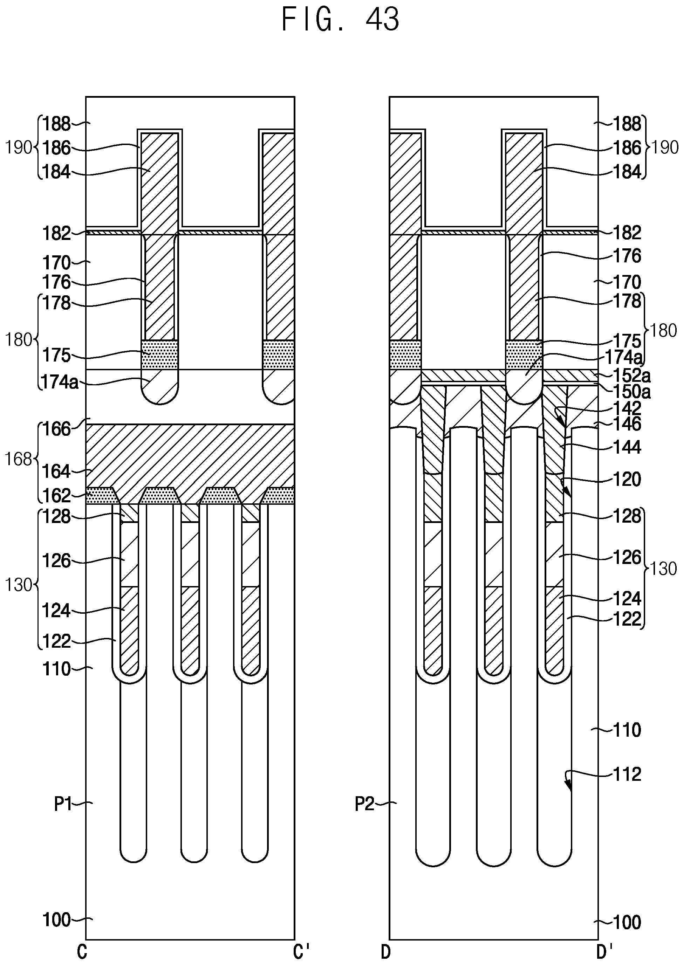

Referring to FIGS. 42 and 43, an etch stop layer 182 may be formed on the second contact plugs 178 and the first mold layer 170. The etch stop layer 182 may include silicon nitride.

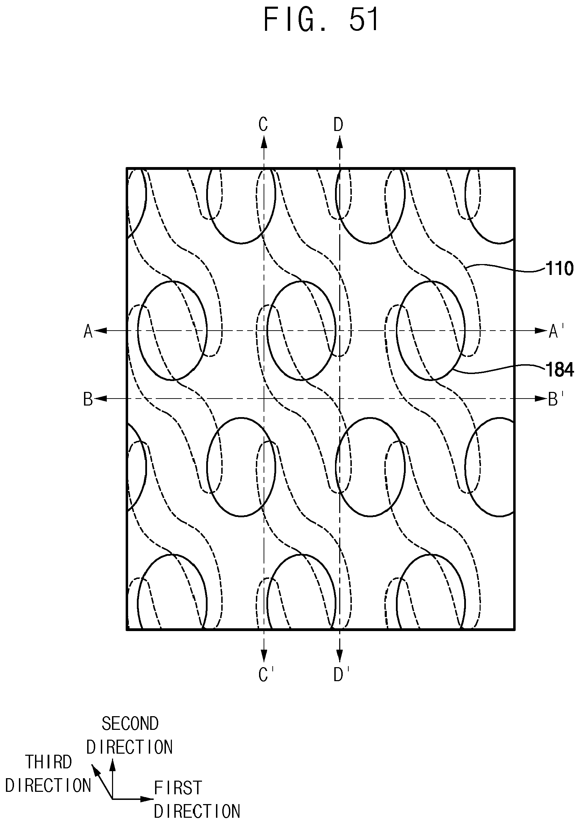

A capacitor 190 may be formed on the second contact plugs 178. The capacitor 190 may include a lower electrode 184, a dielectric layer 186, and an upper electrode 188. The lower electrode 184 may pass through the etch stop layer 182, and may contact the second contact plug 178. A plurality of lower electrodes 184 may be arranged in the honeycomb structure, e.g., see FIG. 51. In some implementations, the lower electrode 184 may have a pillar shape or a cylinder shape.

By the above process, the semiconductor device described with reference to FIGS. 1 to 4 may be manufactured.

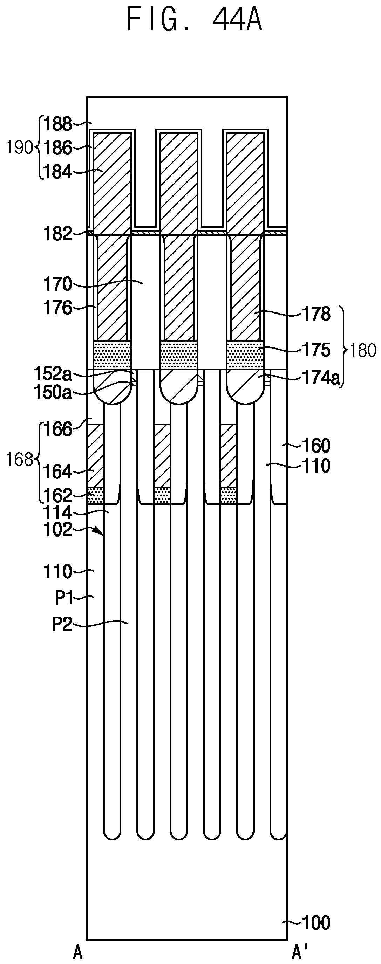

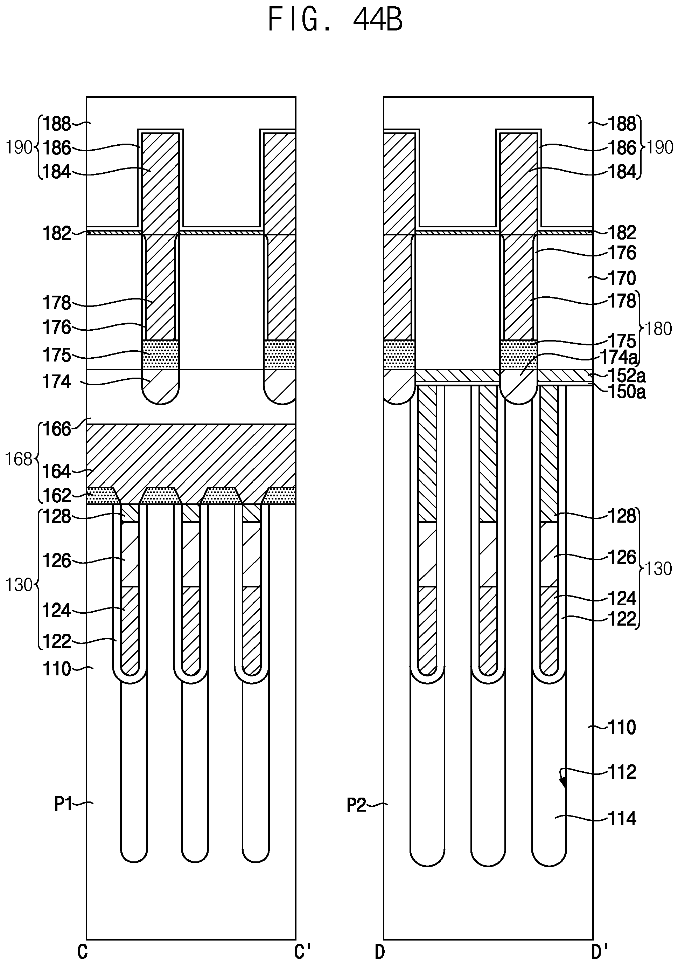

FIGS. 44A and 44B are cross-sectional views for illustrating examples of semiconductor devices.

FIG. 44A includes a cross-sectional view taken along line A-A' of FIG. 2, and FIG. 44B includes cross-sectional views taken along line C-C' and line D-D'.

The semiconductor device shown in FIGS. 44A and 44B may be substantially the same as the semiconductor device described with reference to FIGS. 2 to 4, except that the first contact plug may not be formed on the second portion P2 of the active pattern 110. Therefore, redundant descriptions are omitted.

Referring to FIGS. 44A and 44B, the second contact structure 180 may contact the second portion P2 of the active pattern 110.

In some implementations, the second contact structure 180 may be offset relative to the second portion P2 of the active pattern 110, and may contact a portion of the second portion P2 of the active pattern 110. For example, a center of a bottom of the second contact structure 180 and a center of an upper surface of the second portion P2 of the active pattern 110 may not coincide. A plurality of second contact structures 180 may be arranged in the honeycomb structure.

A bottom of the second contact structure 180 may contact the second portion P2 of the active pattern 110, the first and second buffer layer patterns 150a and 152a, and the insulation spacer 160 adjacent thereto. A lowermost surface of the second contact structure 180 may be lower than an uppermost surface of the second portion P2 of the active pattern 110.

In some implementations, the second contact structure 180 may include a second silicon pattern 174a doped with impurities, a second metal silicide pattern 175, and a second contact plug 178. A stacked structure of the second contact structure 180 may be the same as those described with reference to FIGS. 2 to 4.

The capacitor 190 may be formed on the second contact structure 180. The lower electrode 184 of the capacitor 190 may be electrically connected to the second portion P2 of the active pattern 110 via the second contact structure 180.

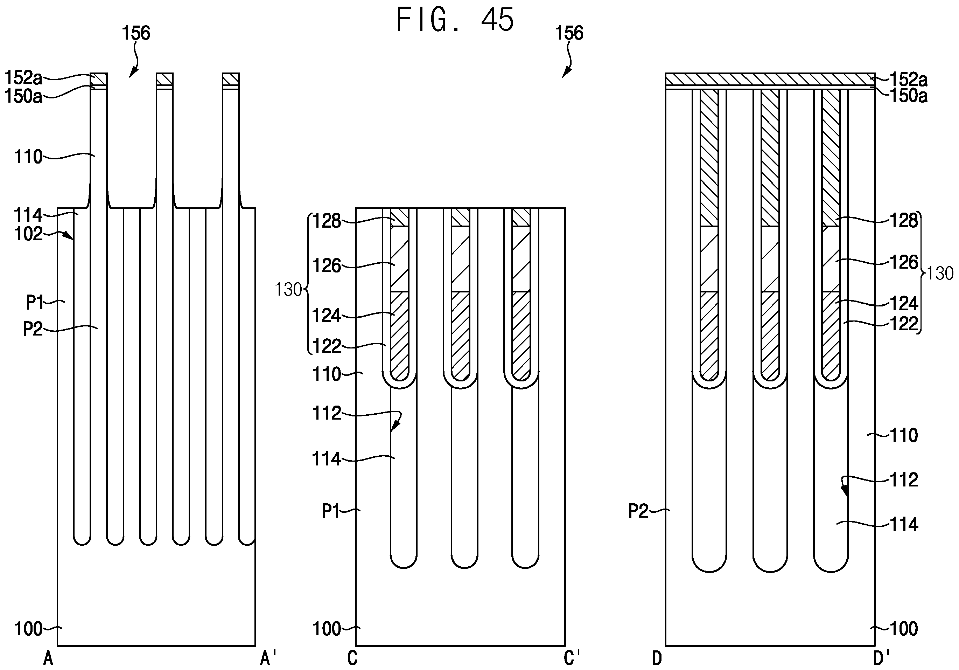

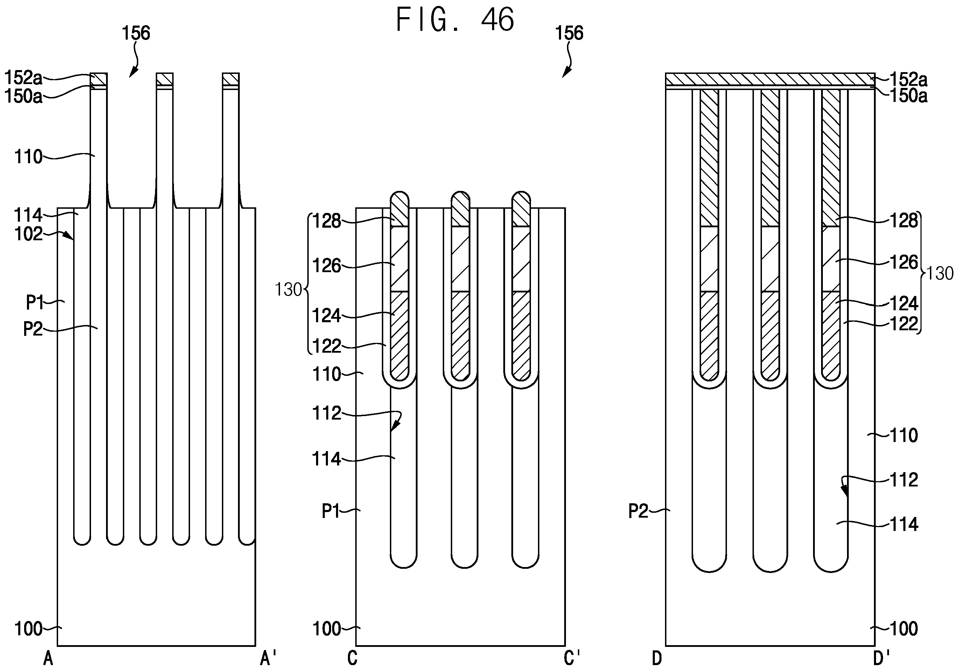

FIGS. 45 and 46 are cross-sectional views for illustrating examples of methods of manufacturing a semiconductor device. Each of FIGS. 45 and 46 includes cross-sectional views taken along lines A-A', C-C', and D-D' of FIG. 2.

The method of manufacturing the semiconductor device shown in FIGS. 44A and 44B may be the same as the method described with reference to FIGS. 6 to 43, except that the process for forming the first contact plug may be omitted.

Referring to FIG. 45, the processes described with reference to FIGS. 6 to 14 may be performed in the same manner. Thereafter, first and second buffer layers may be formed to cover the active pattern 110, the device isolation pattern 114, and the gate structure 130.

An etch mask having a liner shape extending in the second direction and covering the second portion P2 of the active pattern 110 may be formed on the second buffer layer. The etch mask may expose the first portion P1 of the active pattern 110 and a portion of the gate structure 130.

The first and second buffer layers, an upper portion of the first portion P1 of the active pattern 110, and an upper portion of the gate mask 128 may be etched to form the second opening 156. The first and second buffer layers may be transformed into the first and second buffer layer patterns 150a and 152a by the second opening 156. The first and second buffer layer patterns 150a and 152a may extend in the second direction while covering the second portions P2 of the active patterns 110.

The second opening 156 may extend in the second direction while exposing the first portions P1 of active patterns 110. The first portions P1 of the active patterns 110, the device isolation pattern 114, and the gate masks 128 may be exposed by a bottom of the second opening 156. An upper surface of the first portion P1 of the active pattern 110 exposed by the bottom of the second opening 156 may be lower than an upper surface of the second portion P2 of the active pattern 110.

In some implementations, the device isolation pattern 114, the active pattern 110, and the gate mask 128 may be etched at substantially the same etch rate. In this case, as shown in FIG. 45, upper surfaces of the first portion P1 of the active patterns 110 and the gate mask 128 exposed by the bottom of the second opening 156 may be coplanar with each other.

In some implementations, the gate mask 128 may be etched to have an etch rate lower than etch rates of the device isolation pattern 114 and the active pattern 110. In this case, as shown in FIG. 46, the first portion P1 of the active patterns 110 exposed by the bottom of the second opening 156 may be lower than the upper surface of the gate mask 128 exposed by the bottom of the second opening 156. The gate mask 128 exposed by the bottom of the second opening 156 may protrude from the first portion P1 of the active patterns 110 exposed by the bottom of the second opening 156.

Thereafter, processes as those described with reference to FIGS. 26 to 43 may be performed to manufacture the semiconductor device including the gate mask 128 protruding from the first portion P1 of the active patterns 110.

The semiconductor device may not include the first contact plug, simplifying the structure of the semiconductor device. Therefore, the manufacturing process of the semiconductor device may be simplified.

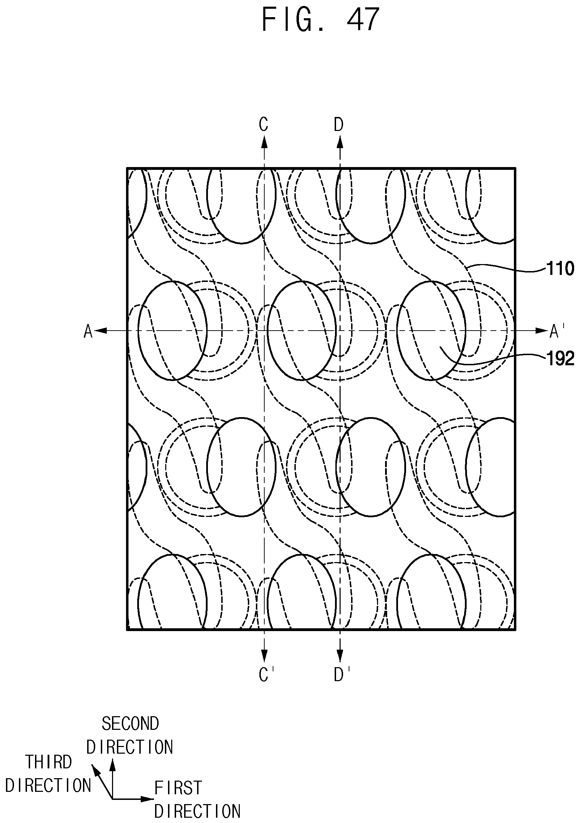

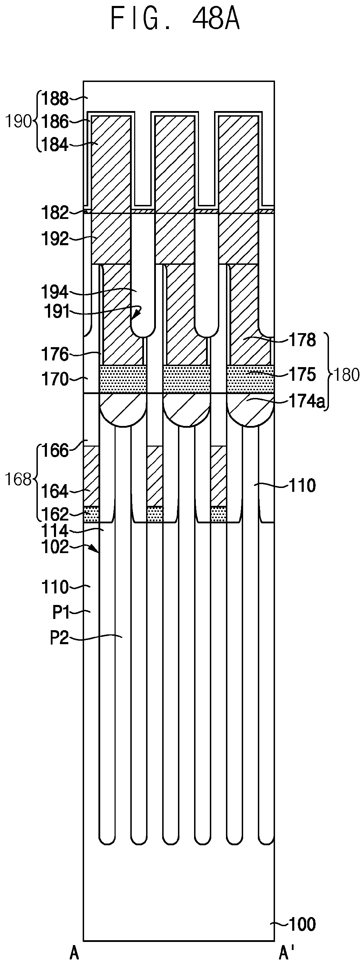

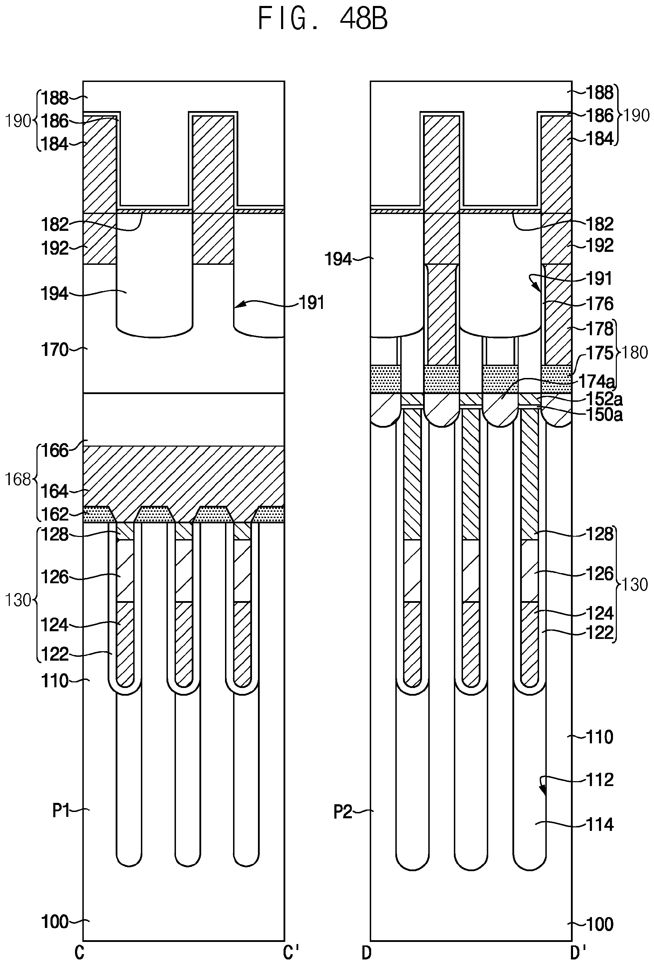

FIG. 47 is a plan view illustrating an example of a semiconductor device. FIGS. 48A and 48B are cross-sectional views illustrating examples of semiconductor devices.

FIG. 47 illustrates only some components of the semiconductor device. FIG. 48a includes cross-sectional view taken along line A-A' of FIG. 47, and FIG. 48b includes cross-sectional views taken along line C-C' and line D-D' of FIG. 47.

The semiconductor device shown in FIGS. 47, 48A, and 48B may be substantially the same as the semiconductor device described with reference to FIG. 44, except for the second contact structure and the landing pad pattern. Therefore, redundant descriptions may be omitted.

Referring to FIGS. 47, 48A, and 48B, the second contact structure 180 may contact the second portion P2 of the active pattern 110.

In some implementations, the second contact structure 180 may be accurately aligned with an upper surface of the second portion P2 of the active pattern 110. A bottom of the second contact structure 180 may contact an entire upper surface of the second portion P2 of the active pattern 110.

The bottom of the second contact structure 180 may contact the second portion P2 of the active pattern 110 and the insulation spacer 160 adjacent thereto.

In some implementations, the second contact structure 180 may include the second silicon pattern 174a doped with impurities, the second metal silicide pattern 175, and the second contact plug 178 stacked. The stacked structure of the second contact structure 180 may be the same as those described with reference to FIGS. 2 to 4.

A landing pad pattern 192 may be formed on the second contact structure 180. The landing pad pattern 192 may include a metal, e.g., tungsten.

The landing pad pattern 192 may not be offset relative to an upper surface of the second contact structure 180, but may contact at least a portion of the upper surface of the second contact structure 180. A plurality of landing pad patterns 192 may be arranged in the honeycomb structure. A bottom of the landing pad pattern 192 may contact upper surfaces of the second contact structure 180 and the second insulation pattern 166.

A third opening 191 may be formed between the landing pad patterns 192. A portion of the second contact structure 180 may be exposed by a lower sidewall of the third opening 191. A bottom of the third opening 191 may be lower than an uppermost surface of the second contact structure 180. That is, the portion of the second contact structure 180 exposed by the third opening 191 may have a recessed shape.

The uppermost surface of the second contact structure 180 may be higher than an uppermost surface of the bit line structure 168.

A third insulation pattern 194 may be formed in the third opening 191. The third insulation pattern 194 may include silicon nitride.

Upper surfaces of the landing pad pattern 192 and the third insulation pattern 194 may be coplanar with each other and may be substantially flat.

The etch stop layer 182 may be on the landing pad patterns 192 and the third insulation pattern 194. The capacitor 190 may pass through the etch stop layer 182 and may contact the landing pad pattern 192. The lower electrode 184 of the capacitor 190 may pass through the etch stop layer 182, and may contact the landing pad pattern 192. Accordingly, the lower electrode 184 of the capacitor 190 may be electrically connected to the second portion P2 of the active pattern 110 via the landing pad pattern 192 and the second contact structure 180.

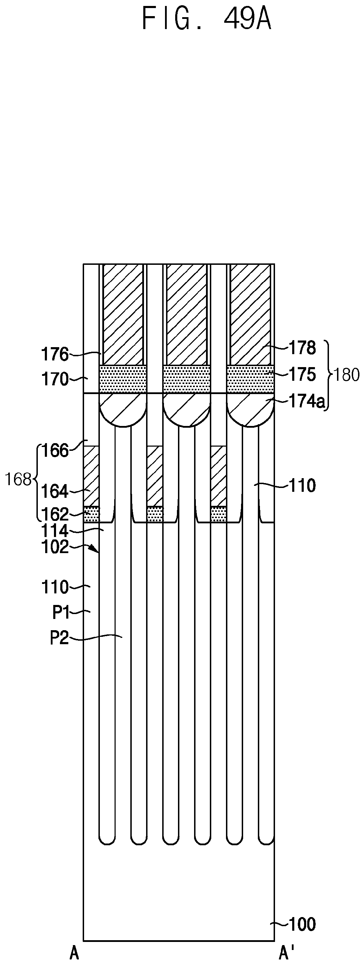

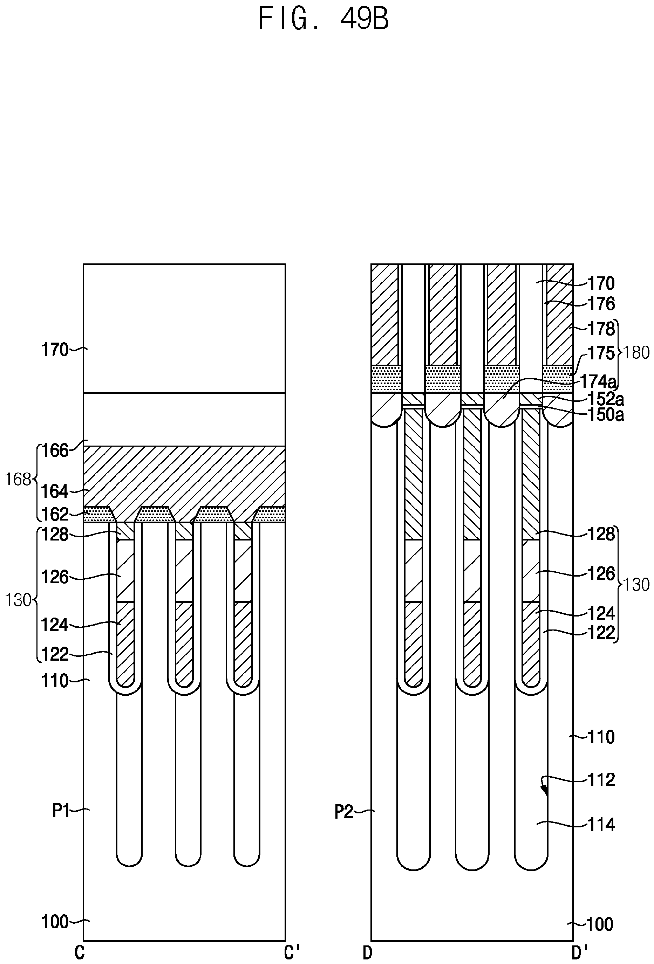

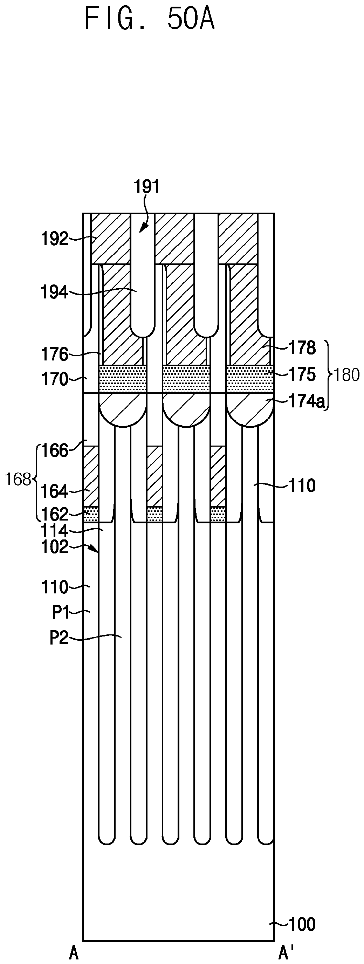

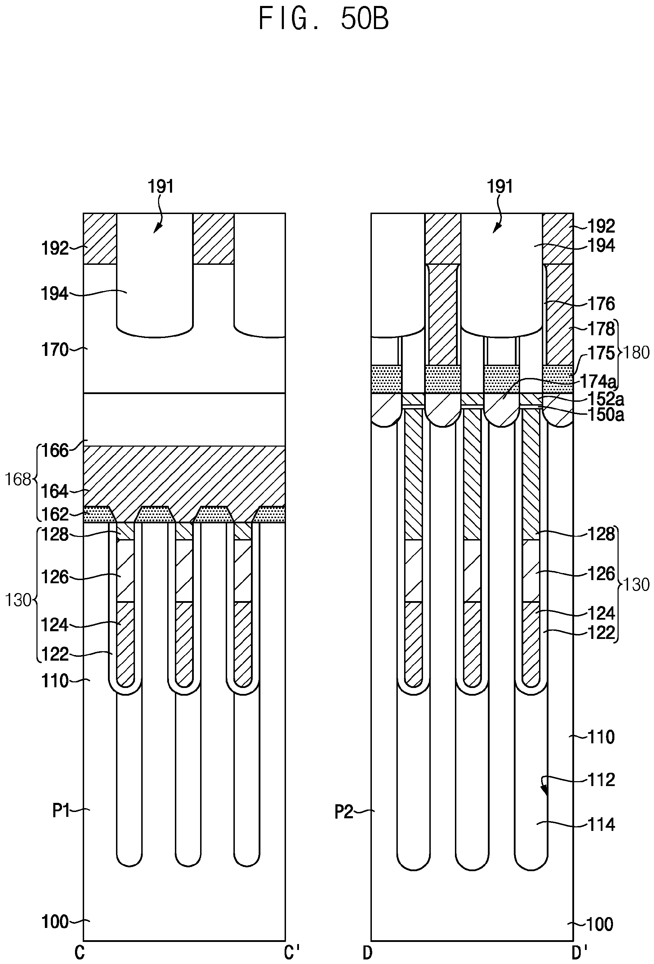

FIGS. 49A, 49B, 50A, and 50B are cross-sectional views for illustrating an example of a method of manufacturing a semiconductor device.

FIGS. 49A and 50A are cross-sectional views taken along line A-A' in FIG. 47. FIGS. 49B and 50B are cross-sectional views along lines C-C' and lines D-D'.

The method of manufacturing the semiconductor device may be substantially the same as the method of manufacturing the semiconductor device described with reference to FIG. 45, except for processes for forming the second contact plug and the landing pad pattern.

Referring to FIGS. 49A and 49B, the processes described with reference to FIGS. 6 to 14 may be performed in the same manner.

Thereafter, the first and second buffer layers and the etch mask may be formed to cover the active pattern 110, the device isolation pattern 114, and the gate structure 130. The first and second buffer layers and an upper portion of the gate mask may be etched using the etch mask to form a second opening. The second opening may extend in the second direction while exposing the first portions P1 of the active patterns 110.

Subsequently, the processes described with reference to FIGS. 26 to 35 may be performed.

Thereafter, the first mold layer 170 may be formed on the second insulation pattern 166, the second buffer layer pattern 152a, and the insulation spacer 160.

A portion of the first mold layer 170 may be etched, and the first and second buffer layer patterns 150a and 152a, an upper portion of the second portion P2 of the active pattern 110, and the insulation spacer 160 below the first mold layer 170 may be etched to form a second contact hole. The second portion P2 of the active pattern 110 and the insulation spacer 160 adjacent thereto may be exposed by a bottom of the second contact hole. The second contact hole 172 of FIG. 39 may be aligned relative to the second portion P2 of the active pattern 110. For example, the second contact hole 172 overlaps the second potion P2 of the active pattern 110 from a plan view.

An inner spacer 176 may be formed on a sidewall of the second contact hole. The second silicon pattern 174a, the second metal silicide pattern 175, and the second contact plug 178 may be formed on the second portion P2 of the active pattern 110 in the second contact hole. Upper surfaces of the second contact plug 178 and the first mold layer 170 may be coplanar with each other and may be substantially flat.

Referring to FIGS. 50A and 50B, a third conductive layer may be formed on the second contact plug 178 and the first mold layer 170. The third conductive layer may include a metal, e.g., tungsten.

The third conductive layer, the second contact plug 178, the inner spacer 176, and the first mold layer 170 below the third conductive layer may be etched to form a landing pad pattern 192 and a third opening 191. The landing pad pattern 192 may be formed by etching the third conductive layer, and may contact a portion of the upper surface of the second contact plug 178. The third opening 191 may be formed between the landing pad patterns 192.

A bottom of the third opening 191 may be lower than an uppermost surface of the second contact plug 178.

In some implementations, a plurality of landing pad patterns 192 may be arranged in the honeycomb structure.

Thereafter, a third insulation pattern 194 may be formed to fill the third opening 191.

Subsequently, the etch stop layer 182 may be formed on the landing pad patterns 192 and the third insulation pattern 194. The capacitor 190 may be formed through the etch stop layer 182, and may be electrically connected to an upper surface of the landing pad pattern 192. Accordingly, the semiconductor devices shown in FIGS. 47, 48A, and 48B may be manufactured.

Since the semiconductor device further includes the landing pad pattern, a process margin (e.g., alignment margin) for forming the capacitor may be increased.

FIGS. 51, 52, and 53 are plan and cross-sectional views for illustrating examples of semiconductor devices.

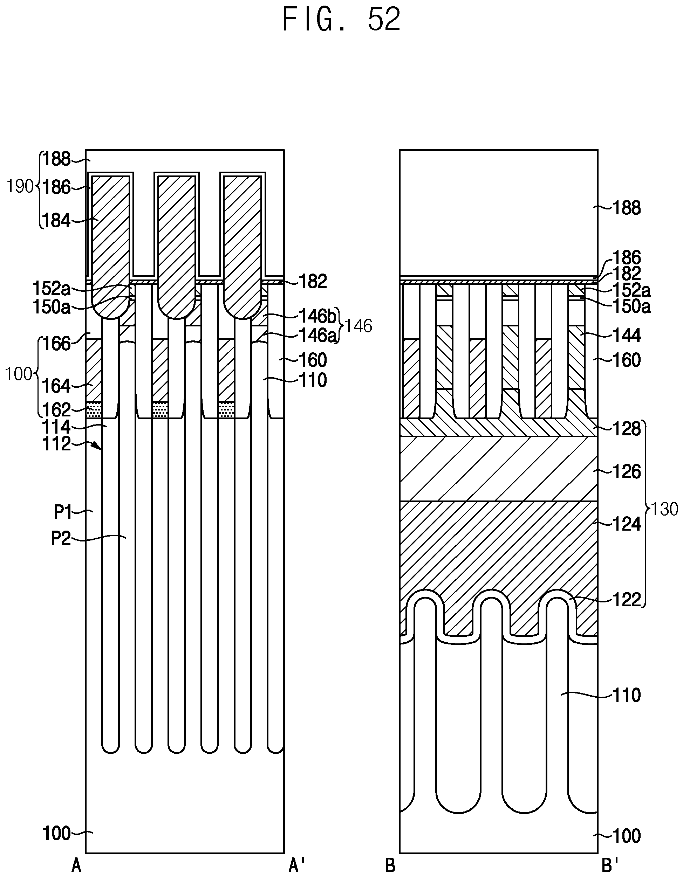

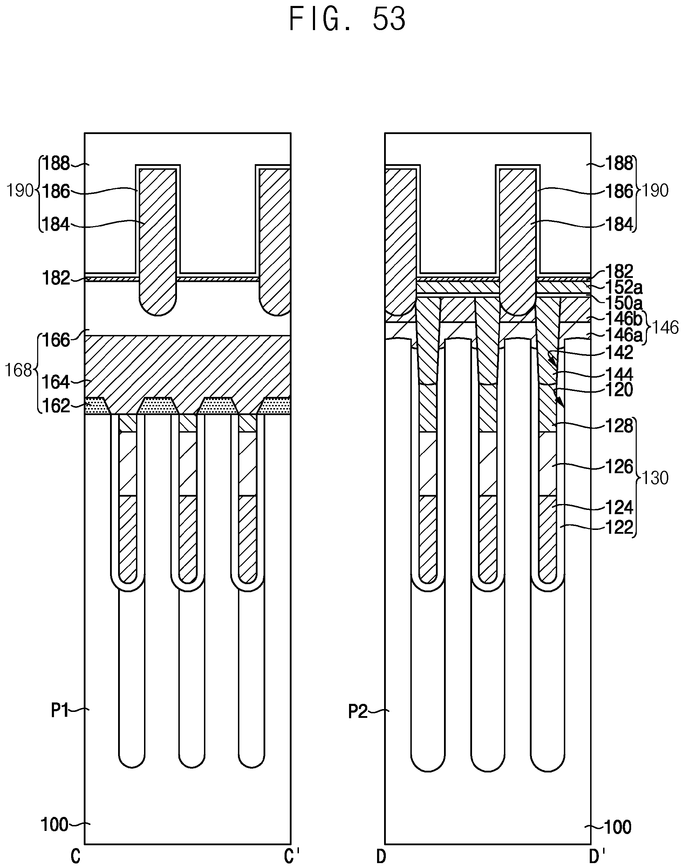

FIG. 51 illustrates only some components of the semiconductor device. FIG. 52 includes cross-sectional views taken along lines A-A' and B-B' of FIG. 51. FIG. 53 includes cross-sectional views taken along lines C-C' and D-D' of FIG. 51.

The semiconductor device shown in FIGS. 51 to 53 is substantially the same as the semiconductor device described with reference to FIGS. 2 to 4, except that the semiconductor device may not include the second contact structure. Therefore, redundant descriptions may be omitted.

Referring to FIGS. 51 to 53, the etch stop layer 182 may cover upper surfaces of the insulation spacer 160, the second buffer layer pattern 152a, and the second insulation pattern 166.

The lower electrode 184 of the capacitor 190 may pass through the etch stop layer 182 and may contact the first contact plug 146.

In some implementations, the first contact plug 146 may include a metal silicide pattern 146a and a metal pattern 146b.

The lower electrode 184 may contact a portion of the upper surface of the first contact plug 146. The lower electrode 184 may be electrically connected to the second portion P2 of the active pattern via the first contact plug 146.

A center of a bottom of the lower electrode 184 may not be aligned with a center of an upper surface of the first contact plug 146. The center of the bottom of the lower electrode 184 and the center of the upper surface of the first contact plug 146 may be misaligned relative to each other. The lower electrode 184 may contact a portion of the upper surface of the first contact plug 146.

In some implementations, the bottom of the lower electrode 184 may contact the first contact plug 146, the first and second buffer layer patterns 150a and 152a, the insulation spacer 160 adjacent thereto, and the second insulation pattern 166. The bottom of the lower electrode 184 may be lower than an uppermost surface of the first contact plug 146.

A plurality of lower electrodes 184 may be arranged in the honeycomb structure. The dielectric layer 186 and the upper electrode 188 may be on the lower electrode 184. Accordingly, the capacitor 190 may directly contact the first contact plug 146.

Hereinafter, a method of manufacturing the semiconductor device may be briefly described.

First, the process described with reference to FIGS. 6 to 32 may be performed, and then the etch stop layer may be formed to cover upper surfaces of the insulation spacer 160, the second buffer layer pattern 152a, and the second insulation pattern 166. The capacitor 190 may be formed on the first contact plug 146 through the etch stop layer 181.

The semiconductor device may not include the second contact structure and the landing pad pattern. Therefore, the semiconductor device may be manufactured by the described process.

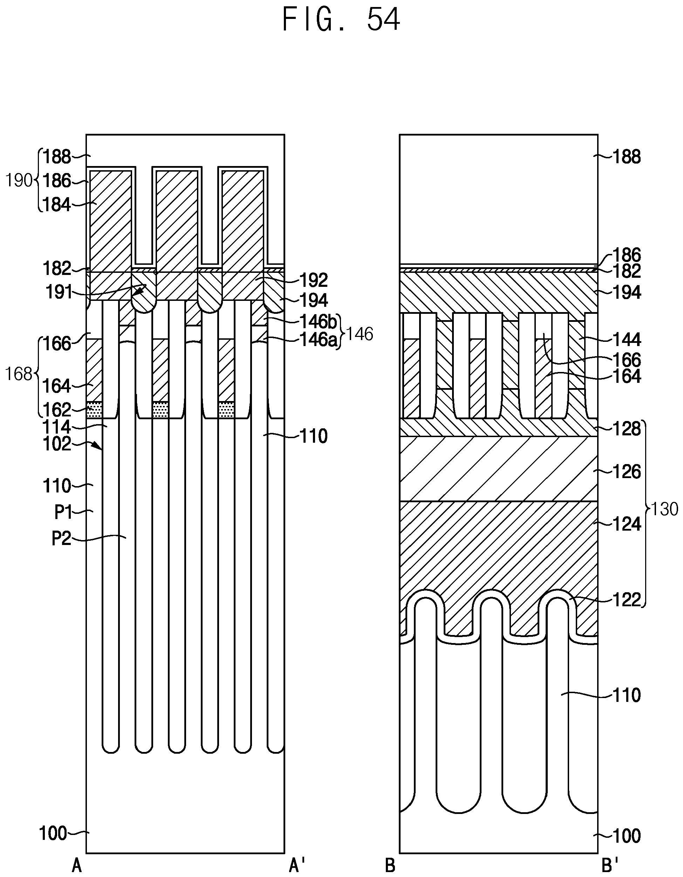

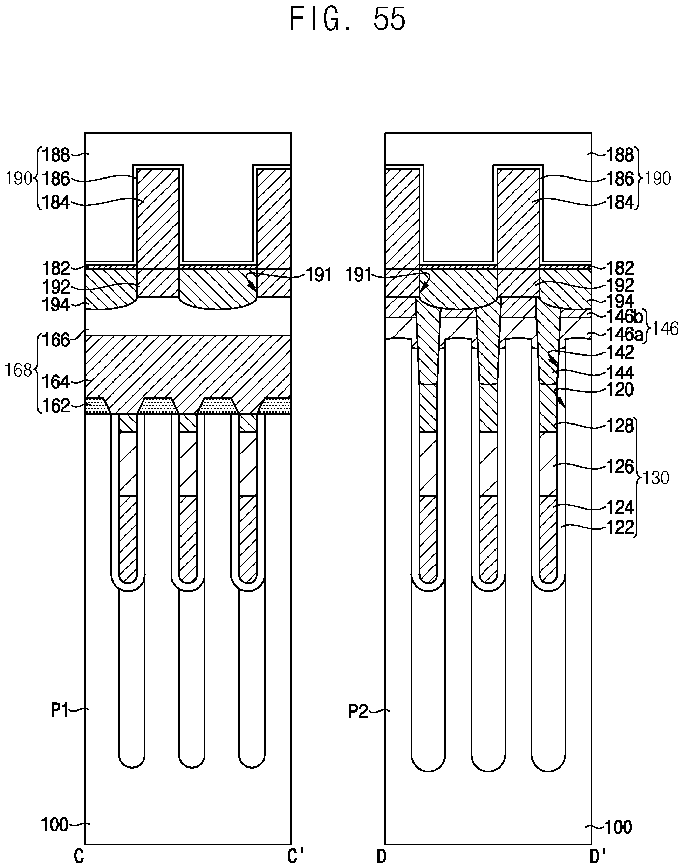

FIGS. 54 and 55 are cross-sectional views for illustrating examples of semiconductor devices.

FIG. 54 includes cross-sectional views taken along lines A-A' and B-B' of FIG. 1. FIG. 55 includes cross-sectional views taken along lines C-C' and D-D' of FIG. 2.

The semiconductor device shown in FIGS. 54 and 55 may be similar to those described with reference to FIGS. 2 to 4, except that the semiconductor device may not include the second contact structure and the first and second buffer layer patterns and may further include a landing pad pattern. Therefore, redundant descriptions may be omitted.

Referring to FIGS. 54 and 55, a landing pad pattern 192 contacting the first contact plug 146 may be on the upper surface of the insulation spacer 160, the first contact plug, and the second insulation pattern 166.

The first and second buffer layer patterns may not be on the first contact plug 146. In some implementations, the first contact plug 146 may include the metal silicide pattern 146a and the metal pattern 146b.

The landing pad pattern 192 may not be accurately aligned to an upper surface of the first contact plug 146, but may contact a portion of the upper surface of the first contact plug 146. A plurality of landing pad patterns 192 may be arranged in the honeycomb structure. The bottom of the landing pad pattern 192 may contact upper surfaces of the first contact plug 146, the insulation spacer 160, and the second insulation pattern.

A third opening 191 may be formed between the landing pad patterns 192, and the first contact plug 146 may be exposed by a lower portion of the third opening 191. A bottom of the third opening 191 may be lower than an uppermost surface of the first contact plug 146. That is, the upper surface of the first contact plug 146 exposed by the third opening 191 may have a recessed shape.

A third insulation pattern 194 may be in the third opening 191. The third insulation pattern 194 may include silicon nitride.

Upper surfaces of the landing pad pattern 192 and the third insulation pattern 194 may be coplanar with each other and may be substantially flat.

The etch stop layer 182 may be on the landing pad patterns 192 and the third insulation pattern 194. The capacitor 190 may pass through the etch stop layer 182, and may contact the upper surface of the landing pad pattern 192.

Hereinafter, a method of manufacturing the semiconductor device may be briefly described.

First, the processes described with reference to FIGS. 6 to 32 may be performed. However, when the processes described with reference to FIGS. 30 to 32 are performed, the first and second buffer layer patterns 150a and 152a may be completely removed by the planarization process. Accordingly, upper surfaces of the second insulation pattern 166, the insulation spacer 160, the first contact plug, and the first insulation pattern 144 may be exposed after the planarization process.

Thereafter, a third conductive layer may be formed on the second insulation pattern 166, the insulation spacer 160, the first contact plug 146, and the first insulation pattern 144.

The third conductive layer, the first contact plug 146, the insulation spacer 160, and the second insulation pattern 166 below the third conductive layer may be etched to form the landing pad pattern 192 contacting the upper surface of the first contact plug 146. The third opening 191 may be formed between the landing pad patterns 192.

A bottom of the third opening 191 may be lower than an uppermost surface of the first contact plug 146.

Thereafter, the third insulation pattern 194 may be formed to fill the third opening 191.

Subsequently, the etch stop layer 182 may be formed on the landing pad patterns 192 and the third insulation pattern 194. The capacitor 190 may be formed through etch stop layer 182, and the capacitor 190 may be electrically connected to the upper surface of the landing pad pattern 192. Accordingly, the semiconductor devices shown in FIGS. 54 and 55 may be manufactured.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

The foregoing is illustrative of various examples and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims. Furthermore example embodiments are not necessarily mutually exclusive with one another. For example, some example embodiments may include one or more features described with reference to one or more figures, and may also include one or more other features described with reference to one or more other figures.

Embodiments are set out in the following clauses:
1. A semiconductor device, comprising:
   an active array in which a plurality of active patterns are arranged on a substrate;
   a gate structure extending in a first direction parallel to an upper surface of the substrate and crossing central portions of the active patterns;
   a bit line structure contacting first portions of the active patterns adjacent to a first sidewall of the gate structure, the bit line structure extending in a second direction parallel to the upper surface of the substrate and perpendicular to the first direction; and
   a capacitor electrically connected to a second portion of each of the active patterns adjacent to a second sidewall of the gate structure,
   wherein, in a plan view along a vertical direction perpendicular to the upper surface, an upper end portion of each of the active patterns and a lower end portion of each of the active patterns are arranged to be spaced apart in a third direction intersecting the first direction at an oblique angle, and
   wherein the active patterns that are arranged side by side in the second direction define an active column.
2. The semiconductor device of clause 1, wherein, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.
3. The semiconductor device of clause 1 or clause 2, wherein the third direction corresponds to a direction along which each of the active patterns extends.
4. The semiconductor device of any preceding clause, wherein, in a plan view, the active patterns that are arranged side by side in the first direction define an active row,
   wherein at least a portion of the active patterns included in an even-numbered active row is disposed between adjacent active patterns include in an odd-numbered active row.
5. The semiconductor device of any preceding clause, wherein the gate structure is in a first recess on the active patterns.
6. The semiconductor device of any preceding clause, wherein an upper surface of the first portion of the active pattern is lower than an upper surface of the second portion of the active pattern.
7. The semiconductor device of any preceding clause, wherein an insulation spacer extends in the second direction and is defined between a sidewall of the second portion of the active pattern and a sidewall of the bit line structure.
8. The semiconductor device of any preceding clause, wherein the bit line structure includes a bit line pattern including a conductive material and a first insulation pattern are stacked.
9. The semiconductor device of clause 8, further comprising a metal silicide pattern between the bit line pattern and an upper surface of the first portion of the active pattern.
10. The semiconductor device of any preceding clause, further comprising:
   a first contact plug having an isolated shape and contacting an upper surface of the second portion of each of the active patterns; and
   a second contact structure contacting at least a portion of the upper surface of the first contact plug, and
   wherein the capacitor contacts the second contact structure.
11. The semiconductor device of clause 10, wherein a plurality of second contact structures are arranged in a honeycomb structure disposed at each vertex of connected hexagons and a center of each of the hexagons.
12. The semiconductor device of clause 10 or clause 11, wherein an uppermost surface of the first contact plug is lower than an uppermost surface of the bit line structure.
13. The semiconductor device of any of clauses 10 to 12, further comprising a second insulation pattern between the first contact plugs in the second direction, and
   wherein the first contact plug and the second insulation pattern are aligned with the second direction.
14. The semiconductor device of any preceding clause, further comprising:
   a contact plug contacting an upper surface of the second portion of the active pattern, and an upper portion of the contact plug including a recessed portion;
   a landing pad pattern contacting at least a portion of the upper surface of the contact plug; and
   a third insulation pattern filling an opening between a plurality of landing pad patterns and contacting the recessed portion.
15. The semiconductor device of clause 14, wherein a plurality of landing pad patterns are arranged in a honeycomb structure disposed at each vertex of connected hexagons and a center of each of the hexagons.
16. The semiconductor device of clause 14 or clause 15, wherein an uppermost surface of the contact plug is higher than an uppermost surface of the bit line structure.
17. The semiconductor device of any preceding clause, further comprising a first contact plug having an isolated shape and contacting an upper surface of the second portion of each of the active patterns, and
   wherein the capacitor contacts at least a portion of the upper surface of the first contact plug.
18. The semiconductor device of clause 17, wherein the capacitor includes a lower electrode, a dielectric layer, and an upper electrode, and
   wherein a plurality of lower electrodes are arranged in a honeycomb structure disposed at each vertex of connected hexagons and a center of each of the hexagons.
19. A semiconductor device, comprising:
   an active array in which a plurality of active patterns are arranged on a substrate;
   a gate structure extending in a first direction parallel to an upper surface of the substrate and crossing central portions of the active patterns, wherein each of the active patterns are divided into a first portion and a second portion by the gate structure;
   a bit line structure i) contacting the first portions of the active patterns, ii) extending in a second direction parallel to the upper surface of the substrate and perpendicular to the first direction, and iii) including a bit line pattern comprising a conductive material stacked on a first insulation pattern; and
   capacitors electrically connected to second portions of the active patterns, respectively,
   wherein, in a plan view along a direction perpendicular to the upper surface, an upper end portion of each of the active patterns and a lower end portion of each of the active patterns are arranged to be spaced apart in a third direction intersecting the first direction at an oblique angle, and
   wherein an upper surface of the first portion of each of the active patterns is lower than an upper surface of the second portion of the active pattern.
20. The semiconductor device of clause 19, wherein the active patterns that are arranged side by side in the second direction define an active column, and the active patterns that are arranged side by side in the first direction define an active row, and
   wherein first portions of the active patterns included in the active column are arranged in the second direction, and central portions of active patterns included in the active row are arranged in the first direction.
21. The semiconductor device of clause 19 or clause 20, wherein, in a plan view, a plurality of active columns are repeatedly arranged in the first direction.
22. The semiconductor device of any of clauses 19 to 21, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.
23. The semiconductor device of any of clauses 19 to 22, further comprising a metal silicide pattern between the bit line pattern and an upper surface of the first portion of the active pattern.
24. The semiconductor device of any of clauses 19 to 23, further comprising:
   a first contact plug having an isolated shape and contacting an upper surface of the second portion of each of the active patterns; and
   a second contact structure contacting at least a portion of the upper surface of the first contact plug, wherein the capacitor contacts the second contact structure.
25. A semiconductor device, comprising:
   an active array in which a plurality of active patterns are arranged on a substrate;
   a gate structure extending in a first direction parallel to an upper surface of the substrate and crossing central portions of the active patterns, wherein each of the active patterns are divided into a first portion and a second portion by the gate structure;
   a bit line structure i) contacting the first portions of the active patterns, ii) extending in a second direction parallel to the upper surface of the substrate and perpendicular to the first direction, and iii) including a bit line pattern having a conductive material and a first insulation pattern stacked; and
   an insulation spacer disposed between a sidewall of a second portion of the active pattern and a sidewall of the bit line structure, and extending in the second direction;
   first contact plugs contacting upper surfaces of second portions of the active patterns, respectively, and each of the first contact plugs having an isolated shape;
   a second insulation pattern between the first contact plugs in a second direction; and
   a capacitor electrically connected to each of the first contact plugs.
26. The semiconductor device of clause 25, wherein, in a plan view, an upper end portion of each of the active patterns and a lower end portion of each of the active patterns are arranged to be spaced apart in a third direction oblique with respect to the first direction, and
   wherein the active patterns that are arranged side by side in the second direction define an active column, and a plurality of active columns are repeatedly arranged in the first direction.
27. The semiconductor device of clause 26, wherein, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.
28. The semiconductor device of any of clauses 25 to 27, further comprising a second contact structure between the first contact plug and the capacitor, wherein the second contact structure contacts at least a portion of an upper surface of the first contact plug.

## Claims

1. A semiconductor device, comprising:
an active array in which a plurality of active patterns are arranged on a substrate;
a gate structure extending in a first direction parallel to an upper surface of the substrate and crossing central portions of the active patterns;
a bit line structure contacting first portions of the active patterns adjacent to a first sidewall of the gate structure, the bit line structure extending in a second direction parallel to the upper surface of the substrate and perpendicular to the first direction; and
a capacitor electrically connected to a second portion of each of the active patterns adjacent to a second sidewall of the gate structure,
wherein, in a plan view, an upper end portion of each of the active patterns and a lower end portion of each of the active patterns are arranged to be spaced apart in a third direction intersecting the first direction at an oblique angle, and
wherein the active patterns that are arranged side by side in the second direction define an active column.

2. The semiconductor device of claim 1, wherein, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.

3. The semiconductor device of claim 1 or claim 2, wherein the third direction corresponds to a direction along which each of the active patterns extends.

4. The semiconductor device of any preceding claim, wherein, in a plan view, the active patterns that are arranged side by side in the first direction define an active row,
wherein at least a portion of the active patterns included in an even-numbered active row is disposed between adjacent active patterns include in an odd-numbered active row.

5. The semiconductor device of any preceding claim, wherein the gate structure is in a first recess on the active patterns.

6. The semiconductor device of any preceding claim, wherein an upper surface of the first portion of the active pattern is lower than an upper surface of the second portion of the active pattern.

7. The semiconductor device of any preceding claim, wherein an insulation spacer extends in the second direction and is defined between a sidewall of the second portion of the active pattern and a sidewall of the bit line structure.

8. The semiconductor device of any preceding claim, further comprising:
a first contact plug having an isolated shape and contacting an upper surface of the second portion of each of the active patterns; and
a second contact structure contacting at least a portion of the upper surface of the first contact plug, and
wherein the capacitor contacts the second contact structure.

9. The semiconductor device of claim 8, wherein an uppermost surface of the first contact plug is lower than an uppermost surface of the bit line structure.

10. The semiconductor device of any preceding claim, further comprising:
a contact plug contacting an upper surface of the second portion of the active pattern, and an upper portion of the contact plug including a recessed portion;
a landing pad pattern contacting at least a portion of the upper surface of the contact plug; and
a third insulation pattern filling an opening between a plurality of landing pad patterns and contacting the recessed portion.

11. A semiconductor device, comprising:
an active array in which a plurality of active patterns are arranged on a substrate;
a gate structure extending in a first direction parallel to an upper surface of the substrate and crossing central portions of the active patterns, wherein each of the active patterns are divided into a first portion and a second portion by the gate structure;
a bit line structure i) contacting the first portions of the active patterns, ii) extending in a second direction parallel to the upper surface of the substrate and perpendicular to the first direction, and iii) including a bit line pattern comprising a conductive material stacked on a first insulation pattern; and
capacitors electrically connected to second portions of the active patterns, respectively,
wherein, in a plan view, an upper end portion of each of the active patterns and a lower end portion of each of the active patterns are arranged to be spaced apart in a third direction intersecting the first direction at an oblique angle, and
wherein an upper surface of the first portion of each of the active patterns is lower than an upper surface of the second portion of the active pattern.

12. The semiconductor device of claim 11, wherein the active patterns that are arranged side by side in the second direction define an active column, and the active patterns that are arranged side by side in the first direction define an active row, and
wherein first portions of the active patterns included in the active column are arranged in the second direction, and central portions of active patterns included in the active row are arranged in the first direction.

13. The semiconductor device of claim 11 or claim 12, wherein, in a plan view, a plurality of active columns are repeatedly arranged in the first direction.

14. The semiconductor device of any of claims 11 to 13, wherein, in a plan view, sidewalls of each of the active patterns have one of a straight shape extending in the third direction, a curved shape extending in the third direction, and a shape having an upper portion and a lower portion extending in the second direction and a middle portion between the upper portion and the lower portion and extending in the first direction.

15. The semiconductor device of any of claims 11 to 14, further comprising:
a first contact plug having an isolated shape and contacting an upper surface of the second portion of each of the active patterns; and
a second contact structure contacting at least a portion of the upper surface of the first contact plug, wherein the capacitor contacts the second contact structure.
